# EUROPEAN PATENT APPLICATION

(11) **EP 4 672 212 A1**
(43) Date of publication of application: **31.12.2025**
(21) Application number: 23956503.9
(22) Date of filing: 27.10.2023
(51) Int. Cl.: G09G 3/3233

(54) **DISPLAY SUBSTRATE AND DISPLAY DEVICE**

(71) Applicant: BOE TECHNOLOGY GROUP CO., LTD., Beijing 100015 (CN); Chengdu BOE Optoelectronics Technology Co., Ltd., Chengdu, Sichuan 611731 (CN)
(72) Inventor: GUO, Yonglin, Beijing 100176 (CN); GAO, Wenhui, Beijing 100176 (CN); SONG, Gukhwan, Beijing 100176 (CN); LEE, Youngjang, Beijing 100176 (CN)
(74) Representative: Isarpatent
(86) International application number: PCT/CN2023/127204
(87) International publication number: WO 2025/086260

(57) **Abstract**

A display substrate and a display device are provided. The display substrate includes a plurality of light-emitting control signal lines, a plurality of power lines and a plurality of sub-pixels, where the sub-pixels include a sub-pixel driving circuit and a light-emitting element; the sub-pixel driving circuit include a driving transistor, a power control transistor and a light-emitting control transistor; the first electrode of the power control transistor is coupled to the corresponding power line, and the second electrode of the power control transistor is coupled to the first electrode of the driving transistor; the first electrode of the light-emitting control transistor is coupled to the second electrode of the driving transistor, and the second electrode of the light-emitting control transistor is coupled to the light-emitting element; in the same sub-pixel driving circuit, the gate of the power control transistor and the gate of the light-emitting control transistor are coupled to different light-emitting control signal lines; the light-emitting control signal line include at least two light-emitting control parts arranged along a first direction, two adjacent light-emitting control parts are coupled, and the two adjacent light-emitting control parts are arranged in different layers.

## Description

### TECHNICAL FIELD

The present disclosure relates to the field of display technology, and in particular to a display substrate and a display device.

### BACKGROUND

With the continuous development of display technology, the application fields of display products are becoming more and more extensive, and the display quality requirements of display products are becoming higher and higher. At present, commonly used display products include: active -matrix organic light-emitting diode (AMOLED) display products, liquid crystal display products (LCD), etc.

AMOLED display products generally include sub-pixel driving circuits and light-emitting elements. The sub-pixel driving circuit is used to drive the light-emitting element to emit light, thereby realizing the display function of the display product. The structure and driving method of the sub-pixel driving circuit can affect the display quality of the display product.

### SUMMARY

The present disclosure is to provide a display substrate and a display device.

In order to achieve the above objectives, the present disclosure provides the following technical solutions:
the present disclosure provides a display substrate, including: a base substrate, and a plurality of light-emitting control signal lines, a plurality of power supply lines, and a plurality of sub-pixels, all of which are arranged on the base substrate, where the sub-pixels include a sub-pixel driving circuit and a light-emitting element;
The sub-pixel driving circuit include a driving transistor, a power control transistor and a light-emitting control transistor; a first electrode of the power control transistor is coupled to a corresponding power line, and a second electrode of the power control transistor is coupled to a first electrode of the driving transistor; a first electrode of the light-emitting control transistor is coupled to a second electrode of the driving transistor, and a second electrode of the light-emitting control transistor is coupled to the light-emitting element;
In the same sub-pixel driving circuit, the gate of the power control transistor and the gate of the light-emitting control transistor are coupled to different light-emitting control signal lines; the light-emitting control signal line include at least two light-emitting control parts arranged along a first direction, two adjacent light-emitting control parts are coupled, and two adjacent light-emitting control parts are arranged in different layers.

Optionally, the plurality of light-emitting control signal lines include a plurality of first light-emitting control signal lines and a plurality of second light-emitting control signal lines;
In the same sub-pixel driving circuit, the gate of the power control transistor is coupled to the corresponding first light-emitting control signal line, the gate of the light-emitting control transistor is coupled to the corresponding second light-emitting control signal line, and at least part of the first light-emitting control signal line and at least part of the second light-emitting control signal line are located within the layout area of the same sub-pixel driving circuit.

Optionally, at least a portion of the orthographic projection of the first light-emitting control signal line on the substrate is located between the orthographic projection of the gate of the power control transistor coupled thereto on the substrate and the orthographic projection of the second light-emitting control signal line on the substrate.

Optionally, the display substrate further include a plurality of data lines and a plurality of second scanning lines; the sub-pixel driving circuit further include a data writing transistor, a gate of the data writing transistor is coupled to the corresponding second scanning line, a first electrode of the data writing transistor is coupled to the corresponding data line, and a second electrode of the data writing transistor is coupled to the first electrode of the driving transistor;
In a layout area of a same sub-pixel driving circuit, the first light-emitting control signal line, the second light-emitting control signal line and the second scanning line are arranged in sequence along a second direction, and the second direction intersects with the first direction.

Optionally, the second electrode of the data writing transistor, the first electrode of the driving transistor and the second electrode of the power control transistor are coupled to form a second node portion together; the first electrode of the light-emitting control transistor and the second electrode of the driving transistor are coupled to form a third node portion together;
The orthographic projection of the first light-emitting control signal line on the substrate at least partially overlaps with the orthographic projection of the second node portion on the substrate; and/or, the orthographic projection of the first light-emitting control signal line on the substrate at least partially overlaps with the orthographic projection of the third node portion on the substrate; and/or, the orthographic projection of the second light-emitting control signal line on the substrate at least partially overlaps with the orthographic projection of the second node portion on the substrate.

Optionally, the first light-emitting control signal line include a plurality of first light-emitting control parts and a plurality of second light-emitting control parts, the first light-emitting control parts and the second light-emitting control parts are alternately arranged along a first direction, and adjacent first light-emitting control parts and second light-emitting control parts are coupled; the first light -emitting control part and the gate of the power control transistor are arranged in a different layer, the second light-emitting control part and the gate of the power control transistor are arranged in the same layer, and the orthographic projection of the first light-emitting control part on the substrate at least partially overlaps with the orthographic projection of the second node portion on the substrate; and/or,
The orthographic projection of the first light-emitting control part on the base substrate at least partially overlaps with the orthographic projection of the third node portion on the base substrate; and/or,
The second light-emitting control signal line include a plurality of third light-emitting control parts and a plurality of fourth light-emitting control parts, the third light-emitting control parts and the fourth light-emitting control parts are alternately arranged along a first direction, and adjacent third light-emitting control parts are coupled; the third light-emitting control parts and the gate of the power control transistor are arranged in a different layer, the fourth light-emitting control parts and the gate of the power control transistor are arranged in the same layer, and the orthographic projection of the third light-emitting control parts on the substrate at least partially overlaps with the orthographic projection of the second node portion on the substrate.

Optionally, the display substrate includes a first gate metal layer and a first source-drain metal layer which are sequentially stacked in a direction away from the base substrate;
The first light-emitting control part and the third light-emitting control part are provided in the same layer and material as the first source-drain metal layer; the second light-emitting control part and the fourth light-emitting control part are provided in the same layer and material as the first gate metal layer.

Optionally, the display substrate further include a plurality of first scanning lines; the sub-pixel driving circuit further include a compensation transistor, a gate of the compensation transistor is coupled to the corresponding first scanning line, a first electrode of the compensation transistor is coupled to a second electrode of the driving transistor, and the second electrode of the compensation transistor is coupled to the gate of the driving transistor;
The compensation transistor includes a compensation active layer, where the compensation active layer includes two channel portions and conductor portions respectively coupled to the two channel portions;
The sub-pixel driving circuit also include a shielding portion and a first conductive connection portion; the orthographic projection of the shielding portion on the substrate at least partially overlaps with the orthographic projection of the conductor portion on the substrate; the first conductive connection portion is coupled to the shielding portion and the power line, respectively.

Optionally, the sub-pixel driving circuit also include a storage capacitor, a first plate of the storage capacitor is coupled to the gate of the driving transistor; the first conductive connection portion is also coupled to the second plate of the storage capacitor and/or the first electrode of the power control transistor.

Optionally, the plurality of light-emitting control signal lines include a plurality of third light-emitting control signal lines;
In the same sub-pixel driving circuit, the gate of the light-emitting control transistor is coupled to the corresponding third light-emitting control signal line, at least part of the third light-emitting control signal line is located within the layout area of the same sub-pixel driving circuit, and the gate of the power control transistor is coupled to the third light-emitting control signal line coupled to the gate of the light-emitting control transistor in the previous sub-pixel driving circuit adjacent along the second direction.

Optionally, the sub-pixel driving circuit also include a second conductive connection portion, a first end of the second conductive connection portion is coupled to the gate of the power control transistor in the current sub-pixel driving circuit, and a second end of the second conductive connection portion is coupled to a third light-emitting control signal line coupled to a previous sub-pixel driving circuit adjacent to the current sub-pixel driving circuit along the second direction.

Optionally, the display substrate further include a plurality of data lines and a plurality of second scanning lines; the sub-pixel driving circuit further include a data writing transistor, a gate of the data writing transistor is coupled to the corresponding second scanning line, a first electrode of the data writing transistor is coupled to the corresponding data line, and a second electrode of the data writing transistor is coupled to the first electrode of the driving transistor;
The second electrode of the data writing transistor, the first electrode of the driving transistor and the second electrode of the power control transistor are coupled to form a second node portion together; the orthographic projection of the third light-emitting control signal line on the substrate at least partially overlaps with the orthographic projection of the second node portion on the substrate.

Optionally, the third light-emitting control signal line include a plurality of fifth light-emitting control parts and a plurality of sixth light-emitting control parts, the fifth light-emitting control parts and the sixth light-emitting control parts are alternately arranged along the first direction, and adjacent fifth light-emitting control parts are coupled; the fifth light-emitting control part and the gate of the power control transistor are arranged in a different layer, and the sixth light-emitting control part and the gate of the power control transistor are arranged in the same layer, and the orthographic projection of the fifth light-emitting control part on the substrate at least partially overlaps with the orthographic projection of the second node portion on the substrate.

Optionally, the display substrate includes a first gate metal layer and a first source-drain metal layer which are sequentially stacked in a direction away from the base substrate;
The fifth light-emitting control part is provided in the same layer and the same material as the first source-drain metal layer; and/or the second conductive connection part is provided in the same layer and the same material as the first source-drain metal layer.

Optionally, the display substrate further include a plurality of first initialization signal lines and a plurality of first scanning lines; the sub-pixel driving circuit further include a compensation transistor, a gate of the compensation transistor is coupled to the corresponding first scanning line, a first electrode of the compensation transistor is coupled to the second electrode of the driving transistor, and the second electrode of the compensation transistor is coupled to the gate of the driving transistor;
The compensation transistor include a compensation active layer, where the compensation active layer include two channel portions and conductor portions respectively coupled to the two channel portions;
the sub-pixel driving circuit further comprises a shielding portion, the shielding portion is coupled to the corresponding first initialization signal line; an orthographic projection of the shielding portion on the base substrate at least partially overlaps with an orthographic projection of the conductor portion on the base substrate.

Optionally, the sub-pixel driving circuit also include a first conductive connection portion and a storage capacitor; the first plate of the storage capacitor is coupled to the gate of the driving transistor; the first conductive connection portion is respectively coupled to the power line, the second plate of the storage capacitor, and the first electrode of the power control transistor.

Optionally, the sub-pixel driving circuit further include a storage capacitor, a first plate of the storage capacitor is coupled to the gate of the driving transistor, and a second plate of the storage capacitor is coupled to the power line;
The orthographic projection of the second electrode plate on the base substrate at least partially overlaps with the orthographic projection of the second node portion on the base substrate.

Optionally, an orthographic projection of the second electrode plate on the base substrate at least partially overlaps with an orthographic projection of a third node portion in the sub-pixel driving circuit on the base substrate.

Optionally, the first electrode plate include a first electrode plate body and a first electrode plate protrusion; the second electrode plate include a second electrode plate body and a second electrode plate protrusion;
The orthographic projection of the first electrode main body on the substrate at least partially overlaps with the orthographic projection of the second electrode main body on the substrate; the orthographic projection of the first electrode protrusion on the substrate at least partially overlaps with the orthographic projection of the second electrode protrusion on the substrate;
The orthographic projection of the second electrode plate protrusion on the substrate at least partially overlaps with the orthographic projection of the second node portion on the substrate; and/or the orthographic projection of the second electrode plate protrusion on the substrate at least partially overlaps with the orthographic projection of the third node portion on the substrate.

Optionally, the display substrate include a display area and a peripheral area located around the display area;
The display substrate further include a plurality of first shift register units all located in the peripheral area;
In the same sub-pixel driving circuit, the second light-emitting control signal line coupled to the gate of the light-emitting control transistor is coupled to the corresponding first shift register unit, and the first light-emitting control signal line coupled to the gate of the power control transistor is coupled to the first shift register unit coupled to the gate of the light-emitting control transistor in the sub-pixel driving circuit adjacent along the second direction.

Optionally, the display substrate include a display area and a peripheral area located around the display area;
The display substrate further includes a plurality of first shift register units and a plurality of second shift register units, all of which are located in the peripheral area, and the display area is located between the first shift register units and the second shift register units;
The first shift register unit is coupled to the corresponding first light-emitting control signal line, and the second shift register unit is coupled to the corresponding second light-emitting control signal line.

Based on the technical solution of the above-mentioned display substrate, a second aspect of the present disclosure provides a display device, including the above-mentioned display substrate.

### BRIEF DESCRIPTION OF THE DRAWINGS

The drawings described herein are used to provide a further understanding of the present disclosure and constitute a part of the present disclosure. The illustrative embodiments of the present disclosure and their descriptions are used to explain the present disclosure and do not constitute an improper limitation on the present disclosure. In the drawings:
FIG.1 is a schematic diagram of a first circuit structure of a sub-pixel driving circuit provided in an embodiment of the present disclosure;
FIG.2 is a first timing diagram of a sub-pixel driving circuit provided by an embodiment of the present disclosure;
FIG.3 is a second timing diagram of a sub-pixel driving circuit provided by an embodiment of the present disclosure;
FIG.4 is a schematic diagram of a display substrate provided in an embodiment of the present disclosure in which shift register units are disposed on both sides thereof;
FIG.5 is a schematic diagram of a second circuit structure of a sub-pixel driving circuit provided in an embodiment of the present disclosure;
FIG.6 is a schematic diagram of a third circuit structure of a sub-pixel driving circuit provided in an embodiment of the present disclosure;
FIG.7 is a schematic diagram of a fourth circuit structure of a sub-pixel driving circuit provided in an embodiment of the present disclosure;
FIG.8 is a schematic diagram of a fifth circuit structure of a sub-pixel driving circuit provided in an embodiment of the present disclosure;
FIG.9 is a sixth circuit structure diagram of the sub-pixel driving circuit provided in an embodiment of the present disclosure;
FIG.10 is a schematic cross-sectional view of a film layer provided in an embodiment of the present disclosure;
FIG.11 is a schematic diagram of a first layout of an active layer provided in an embodiment of the present disclosure;
FIG.12 is a schematic diagram of a first layout of a first gate metal layer provided in an embodiment of the present disclosure;
FIG.13 is a schematic diagram of a first layout of an active layer and a first gate metal layer provided in an embodiment of the present disclosure;
FIG.14 is a schematic diagram of a first layout of a second gate metal layer provided in an embodiment of the present disclosure;
FIG.15 is a schematic diagram of a first layout in which a second gate metal layer is added on the basis of FIG13;
FIG.16 is a schematic diagram of a first layout of a first source-drain metal layer provided in an embodiment of the present disclosure;
FIG.17 is a schematic diagram of a first layout of via-holes included in an interlayer insulating layer provided by an embodiment of the present disclosure;
FIG.18 is a schematic diagram of a first layout in which a first source/drain metal layer is added on the basis of FIG15;
FIG.19 is a schematic diagram of a first layout of a second source-drain metal layer provided in an embodiment of the present disclosure;
FIG.20 is a schematic diagram of a first layout of via-holes included in a first planar layer provided by an embodiment of the present disclosure;
FIG.21 is a schematic diagram of a first layout in which a second source/drain metal layer is added on the basis of FIG18;
FIG.22 is a schematic diagram of a first layout of a first gate metal layer, a second gate metal layer, and a first source-drain metal layer provided in an embodiment of the present disclosure;
FIG.23 is a schematic diagram of a first layout of a first source-drain metal layer and a second source-drain metal layer provided in an embodiment of the present disclosure;
FIG.24 is a schematic diagram of a second layout of an active layer provided in an embodiment of the present disclosure;
FIG.25 is a schematic diagram of a second layout of a first gate metal layer provided in an embodiment of the present disclosure;
FIG.26 is a schematic diagram of a second layout of an active layer and a first gate metal layer provided in an embodiment of the present disclosure;
FIG.27 is a schematic diagram of a second layout of a second gate metal layer provided in an embodiment of the present disclosure;
FIG.28 is a schematic diagram of a second layout with a second gate metal layer added on the basis of FIG26;
FIG.29 is a schematic diagram of a second layout of a first source-drain metal layer provided in an embodiment of the present disclosure;
FIG.30 is a schematic diagram of a second layout of via-holes included in the interlayer insulating layer provided by an embodiment of the present disclosure;
FIG.31 is a schematic diagram of a second layout with a first source/drain metal layer added on the basis of FIG28;
FIG.32 is a schematic diagram of a second layout of a second source-drain metal layer provided in an embodiment of the present disclosure;
FIG.33 is a schematic diagram of a second layout of the first gate metal layer, the second gate metal layer, and the first source-drain metal layer provided in an embodiment of the present disclosure;
FIG.34 is a schematic diagram of a second layout of the first source-drain metal layer and the second source-drain metal layer provided in an embodiment of the present disclosure; and
FIG.35 is a schematic diagram of a second layout from the active layer to the second source-drain metal layer provided in an embodiment of the present disclosure.

### DETAILED DESCRIPTION

In order to further illustrate the display substrate and the display device provided by the embodiments of the present disclosure, a detailed description is given below in conjunction with the accompanying drawings.

The specific structures of sub-pixel driving circuits used in display products are varied, and the structure and driving mode of the sub-pixel driving circuits can affect the display quality of the display products. The present disclosure provides a display substrate that is compatible with sub-pixel driving circuits of various structures, effectively improving the display quality of display products.

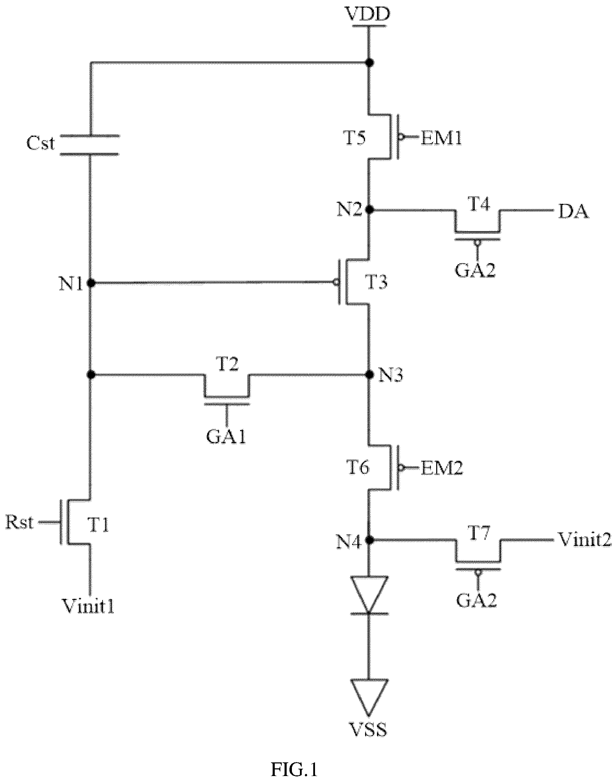

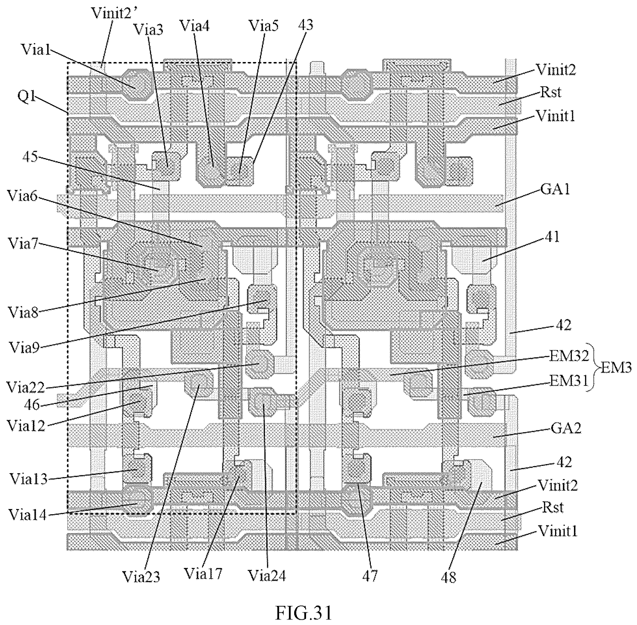

Referring to FIG. 1, FIG. 18 and FIG. 31, an embodiment of the present disclosure provides a display substrate, including: a base substrate, and a plurality of light-emitting control signal lines (such as: a first light-emitting control signal line EM1, a second light-emitting control signal line EM2, and a third light-emitting control signal line EM3), a plurality of power lines VDD, and a plurality of sub-pixels, all of which are arranged on the base substrate, where the sub-pixels include a sub-pixel driving circuit and a light-emitting element;
The sub-pixel driving circuit include a driving transistor T3, a power control transistor T5 and a light-emitting control transistor T6; a first electrode of the power control transistor T5 is coupled to a corresponding power line VDD, and a second electrode of the power control transistor T5 is coupled to a first electrode of the driving transistor T3; a first electrode of the light-emitting control transistor T6 is coupled to a second electrode of the driving transistor T3, and a second electrode of the light-emitting control transistor T6 is coupled to the light-emitting element;
In the same sub-pixel driving circuit, the gate of the power control transistor T5 and the gate of the light-emitting control transistor T6 are coupled to different light-emitting control signal lines; the light-emitting control signal line include at least two light-emitting control parts arranged along a first direction, two adjacent light-emitting control parts are coupled, and two adjacent light-emitting control parts are arranged in different layers.

Exemplarily, the display substrate include a plurality of sub-pixels, and the plurality of sub-pixels include a plurality of sub-pixel driving circuits distributed in an array. The plurality of sub-pixel driving circuits are divided into a plurality of rows of sub-pixel driving circuits and a plurality of columns of sub-pixel driving circuits. The plurality of rows of sub-pixel driving circuits are arranged along a second direction, and each row of sub-pixel driving circuits include a plurality of sub-pixel driving circuits arranged along a first direction. The plurality of columns of sub-pixel driving circuits are arranged along a first direction, and each column of sub-pixel driving circuits include a plurality of sub-pixel driving circuits arranged along a second direction. Exemplarily, the first direction and the second direction intersect. For example, the first direction include a transverse direction, and the second direction include a longitudinal direction.

Exemplarily, the sub-pixel include a sub-pixel driving circuit and a light-emitting element. The sub-pixel driving circuit is coupled to an anode of the light-emitting element and is used to provide a driving signal to the light-emitting element to drive the light-emitting element to emit light.

Exemplarily, the plurality of light-emitting control signal lines are arranged along the second direction, the light-emitting control signal lines include at least a portion extending along the first direction, and the light-emitting control signal lines are used to transmit light-emitting control signals. The plurality of power lines VDD are arranged along the first direction, the power lines VDD include at least a portion extending along the second direction. The plurality of power lines VDD correspond to the plurality of columns of sub-pixel driving circuits one by one, the power lines VDD are respectively coupled to each sub-pixel driving circuit in a corresponding column of sub-pixel driving circuits, and the power lines VDD are used to transmit power signals.

Exemplarily, in the same sub-pixel driving circuit, the gate of the power control transistor T5 and the gate of the light-emitting control transistor T6 are coupled to different light-emitting control signal lines, and the gate of the power control transistor T5 and the gate of the light-emitting control transistor T6 receive light-emitting control signals provided by different light-emitting control signal lines.

Exemplarily, the light-emitting control signal line include a plurality of light-emitting control parts arranged in sequence along the first direction, two adjacent light-emitting control parts are arranged in different layers, and the two adjacent light-emitting control parts are coupled to each other through via-holes. This arrangement enables a portion of the light-emitting control parts among the plurality of light-emitting control parts to form an integrated structure with the gate of the transistor to which they are coupled, thereby ensuring the connection performance and reducing the difficulty of connection, and another portion of the light-emitting control parts is arranged in a different layer from the gate of the transistor, thereby avoiding the formation of an additional abnormal transistor structure between the other portion of the light-emitting control parts and the overlapping active layer, thereby ensuring the stability of the operation of the sub-pixel driving circuit.

According to the specific structure of the display substrate described above, in the display substrate provided by the embodiment of the present disclosure, by being arranged in the same sub-pixel driving circuit, the gate of the power control transistor T5 and the gate of the light control transistor T6 are coupled to different light control signal lines, so that the power control transistor T5 and the light control transistor T6 in the same sub-pixel driving circuit can be independently controlled by different light control signal lines, so that the power control transistor T5 and the light control transistor T6 in the same sub- pixel driving circuit can be controlled to have the same conduction period or different conduction periods according to actual needs. In the display substrate provided by the embodiment of the present disclosure, when the power control transistor T5 in the same sub-pixel driving circuit is controlled to be turned on before the light control transistor T6, the power signal transmitted by the power line VDD can be preferentially written into the first electrode of the driving transistor T3, which is conducive to the improvement of the ghosting phenomenon.

In the display substrate provided in the embodiment of the present disclosure, the sub-pixel driving circuit can be compatible with a variety of circuit structures including the power control transistor T5 and the light emission control transistor T6, such as: 6T1C (i.e., 6 transistors and 1 capacitor) circuit structure, 7T1C (i.e., 7 transistors and 1 capacitor) circuit structure, 8T1C (i.e., 8 transistors and 1 capacitor) circuit structure, 9T1C (i.e., 9 transistors and 1 capacitor) circuit structure, etc., but not limited thereto. In the display substrate provided in the embodiment of the present disclosure, by reasonably controlling the conduction time of the power control transistor T5 and the light emission control transistor T6 in the same sub-pixel driving circuit, the display quality of the display product can be effectively improved.

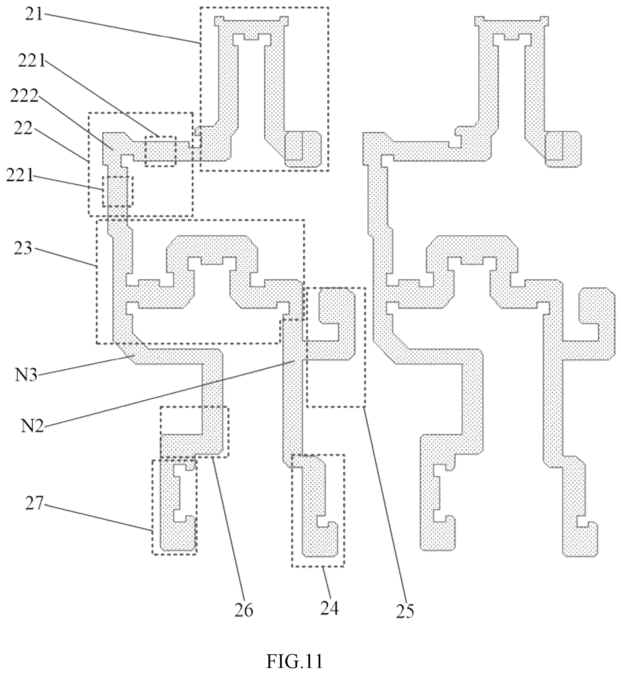

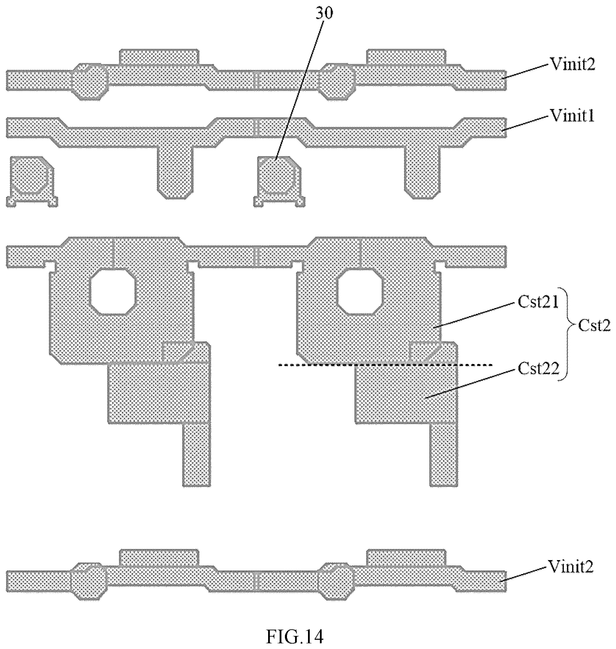

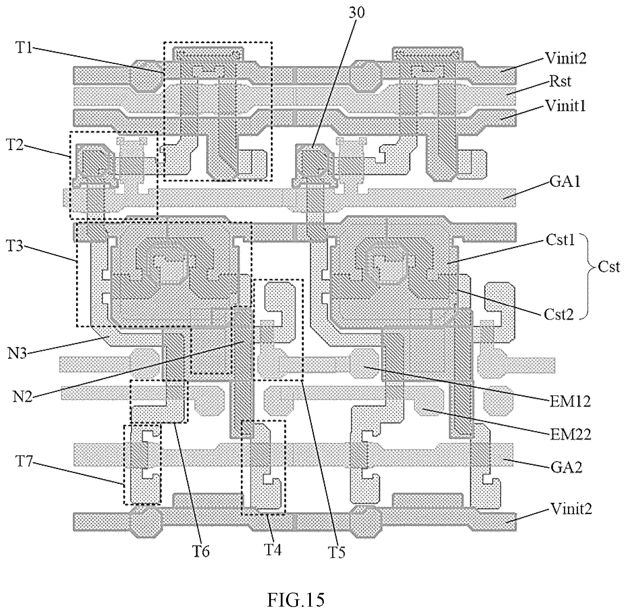

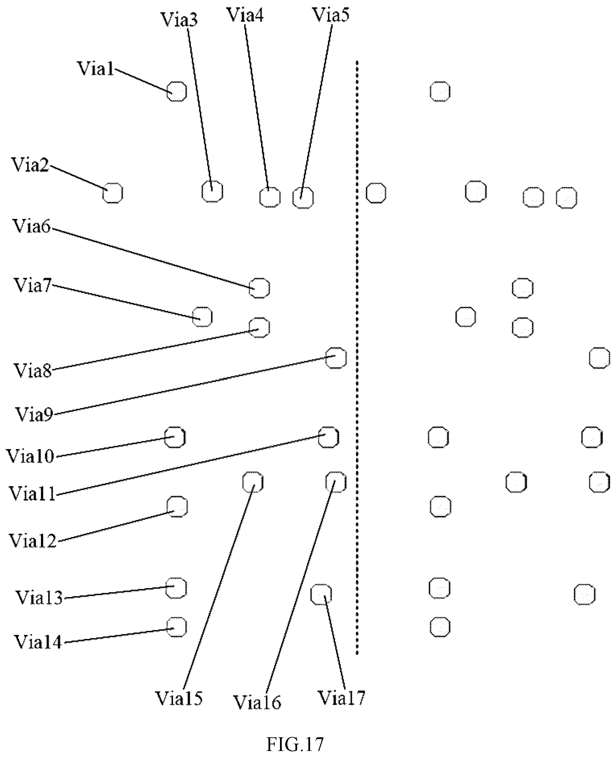

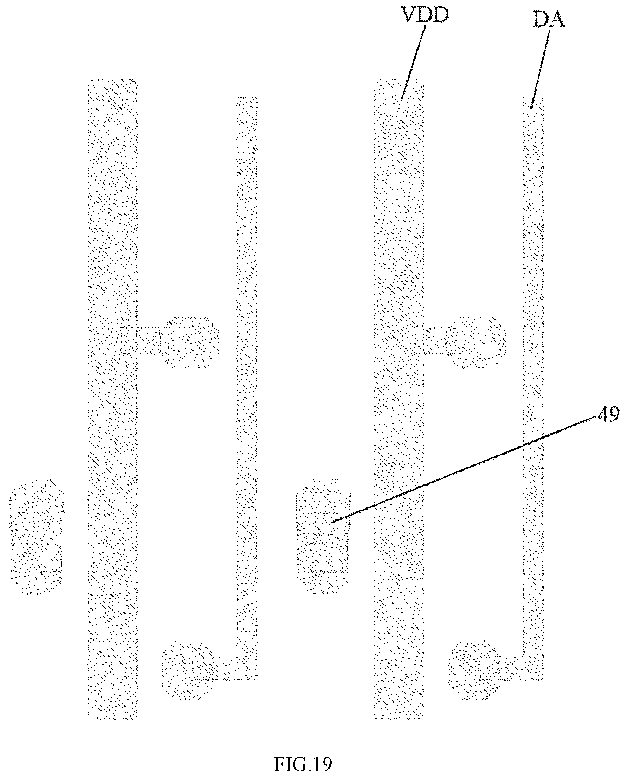

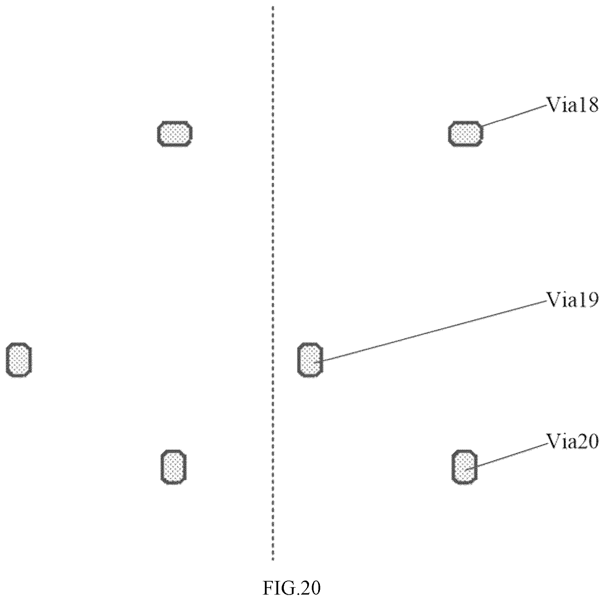

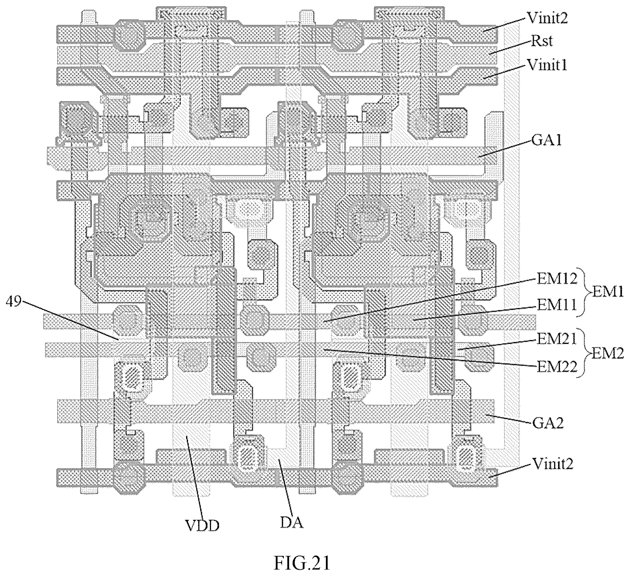

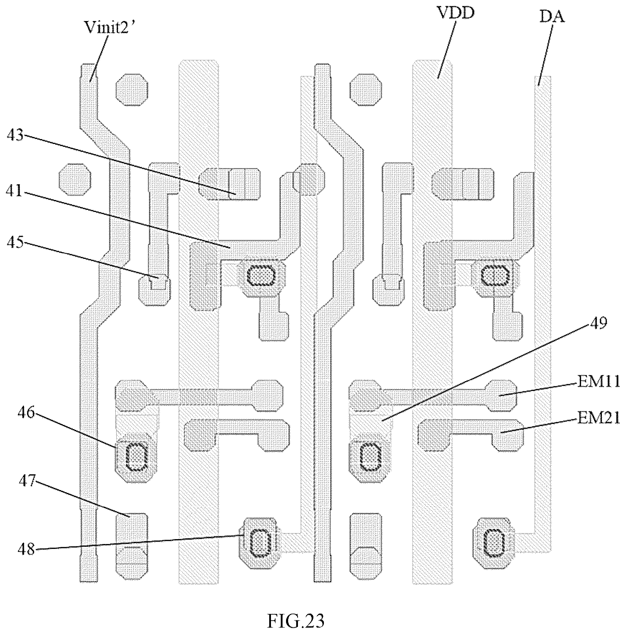

As shown in FIGS. 11 to 23, in some embodiments, the plurality of light-emitting control signal lines include a plurality of first light-emitting control signal lines EM1 and a plurality of second light-emitting control signal lines EM2;
In the same sub-pixel driving circuit, the gate of the power control transistor T5 is coupled to the corresponding first light-emitting control signal line EM1, the gate of the light-emitting control transistor T6 is coupled to the corresponding second light-emitting control signal line EM2, and at least a portion of the first light-emitting control signal line EM1 and at least a portion of the second light-emitting control signal line EM2 are located in the layout area Q1 of the same sub-pixel driving circuit.

Exemplarily, the first light control signal lines EM1 and the second light control signal lines EM2 are alternately arranged along the second direction. The first light control signal lines EM1 include at least a portion extending along the first direction. The second light control signal lines EM2 include at least a portion extending along the first direction.

Exemplarily, the plurality of first light-emitting control signal lines EM1 correspond one-to-one to the plurality of rows of sub-pixel driving circuits, and the first light-emitting control signal lines EM1 are respectively coupled to the gates of the power control transistors T5 in the corresponding row of sub-pixel driving circuits. The plurality of second light-emitting control signal lines EM2 correspond one-to-one to the plurality of rows of sub-pixel driving circuits, and the second light-emitting control signal lines EM2 are respectively coupled to the gates of the light-emitting control transistors T6 in the corresponding row of sub-pixel driving circuits.

Exemplarily, the timings of the light-emitting control signals transmitted by the first light-emitting control signal line EM1 and the second light-emitting control signal line EM2 coupled to the same sub-pixel driving circuit may be the same or different.

The above-mentioned setting method makes each row of sub-pixel driving circuits correspond to a first light-emitting control signal line EM1 and a second light-emitting control signal line EM2, and the first light-emitting control signal line EM1 and the second light-emitting control signal line EM2 are both located in the layout area where the sub-pixel driving circuits of the row are located. This layout method can not only realize the independent control of the power control transistor T5 and the light-emitting control transistor T6 in the same sub-pixel driving circuit, but also makes the power control transistor T5 have a closer distance to the first light-emitting control signal line EM1 coupled to it, and makes the light-emitting control transistor T6 have a closer distance to the second light-emitting control signal line EM2 coupled to it, thereby reducing the layout difficulty of the display substrate.

As shown in FIG. 1, in some embodiments, the display substrate include a power line VDD, a data line DA, a first initialization signal line Vinit1, a second initialization signal line Vinit2, a reset signal line Rst, a first scanning line GA1, a second scanning line GA2, a first light emission control signal line EM1, and a second light emission control signal line EM2. The sub-pixel driving circuit include a driving transistor T3, a first reset transistor T1, a second reset transistor T7, a compensation transistor T2, a data writing transistor T4, a power control transistor T5, a light emission control transistor T6, and a storage capacitor Cst.

The gate of the first reset transistor T1 is coupled to the corresponding reset signal line Rst, the first electrode of the first reset transistor T1 is coupled to the corresponding first initialization signal line Vinit1, and the second electrode of the first reset transistor T1 is coupled to the gate T3 - g (i.e., the first node portion N1) of the driving transistor T3.

The gate of the compensation transistor T2 is coupled to the corresponding first scanning line GA1, the first electrode of the compensation transistor T2 is coupled to the second electrode of the driving transistor T3, and the second electrode of the compensation transistor T2 is coupled to the gate T3 - g of the driving transistor T3.

The gate of the data writing transistor T4 is coupled to the corresponding second scanning line GA2, the first electrode of the data writing transistor T4 is coupled to the corresponding data line DA, and the second electrode of the data writing transistor T4 is coupled to the first electrode of the driving transistor T3.

The gate of the power control transistor T5 is coupled to the corresponding first light-emitting control signal line EM1, the first electrode of the power control transistor T5 is coupled to the corresponding power line VDD, and the second electrode of the power control transistor T5 is coupled to the first electrode of the driving transistor T3.

The gate of the light-emitting control transistor T6 is coupled to the corresponding second light-emitting control signal line EM2, the first electrode of the light-emitting control transistor T6 is coupled to the second electrode of the driving transistor T3, the second electrode of the light-emitting control transistor T6 is coupled to the anode of the corresponding light-emitting element (i.e., the fourth node portion N4), and the cathode of the light-emitting element receives the negative power supply signal VSS.

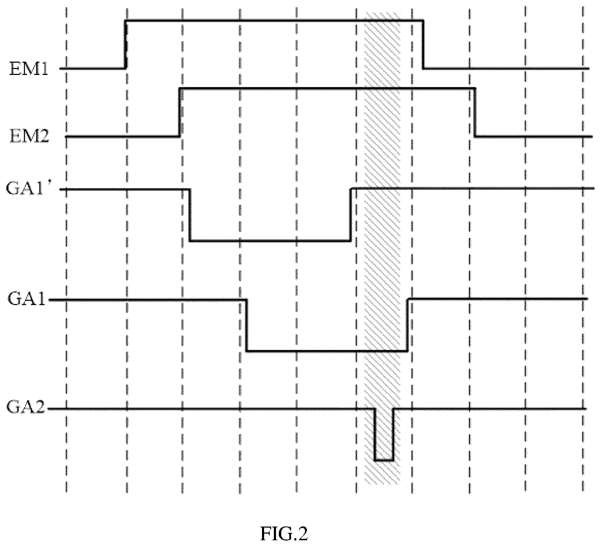

In FIG.2, the working sequence of the sub-pixel driving circuit is illustrated. In the figure, GA1 represents the signal transmitted by the first scanning line GA1 connected to the sub-pixel driving circuit of this row, and GA1' represents the signal transmitted by the first scanning line GA1 connected to the sub-pixel driving circuit of the previous row adjacent to this row. It can be seen from the figure that in the data writing stage, the second scanning signal transmitted by the second scanning line GA2 is at an effective level (such as a low level) to control the writing of the data signal. After the data writing stage is over, the first light-emitting control signal transmitted by the first light-emitting control signal line EM1 is first at an effective level (such as a low level), and the power signal is written, and then the second light-emitting control signal transmitted by the second light-emitting control signal line EM2 is at an effective level (such as a low level), which controls the light-emitting element to emit light, that is, enters the light-emitting stage.

Exemplarily, the compensation transistor T2 and the first reset transistor T1 may be driven by a shift register unit for driving a light-emitting control signal line, or an independent shift register unit specifically used to drive the compensation transistor T2 and the first reset transistor T1 may be provided. For example, when an independent shift register unit specifically used to drive the compensation transistor T2 and the first reset transistor T1 is used, in the n-th row sub-pixel driving circuit, the gate of the compensation transistor T2 is coupled to the corresponding n-th row shift register unit, and the first reset transistor T1 is coupled to the n-7th row shift register unit, but is not limited thereto.

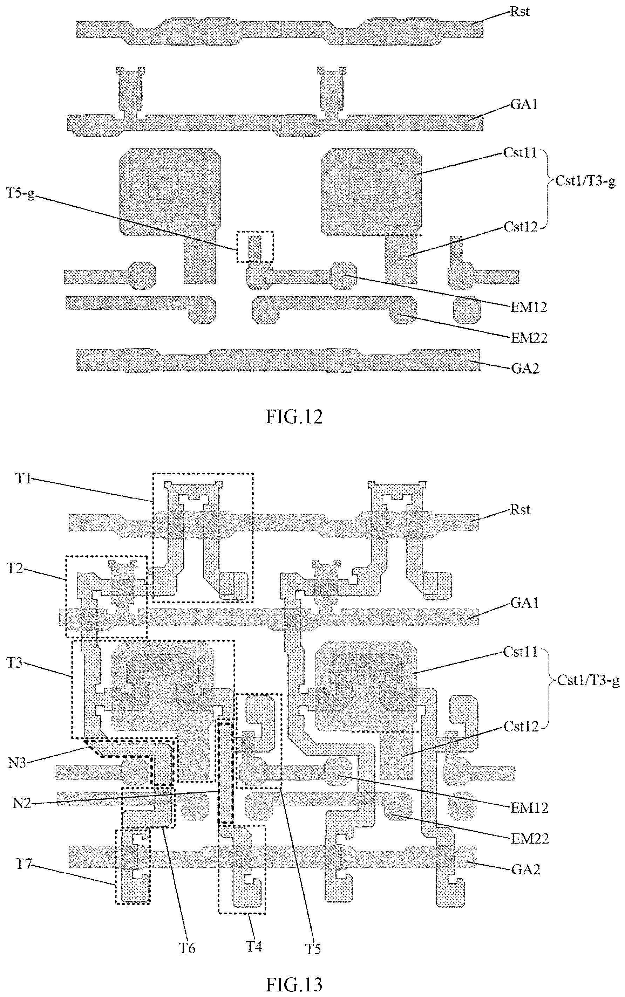

FIGs. 12, 15 and 18, in some embodiments, at least a portion of the orthographic projection of the first light-emitting control signal line EM1 on the base substrate is located between the orthographic projection of the gate T5-g of the power control transistor T5 coupled to it on the base substrate and the orthographic projection of the second light-emitting control signal line EM2 on the base substrate.

As shown in FIGs. 11, 12 and 13, it should be noted that the orthographic projection of the gate T5-g of the power control transistor T5 on the substrate at least partially overlaps with the orthographic projection of the power control active layer 25 on the substrate, and the portion of the power control active layer 25 located in the overlapping area serves as the channel of the power control transistor T5.

Exemplarily, at least part of the orthographic projection of the first light-emitting control signal line EM1 on the substrate is located between the orthographic projection of the gate T3 - g of the driving transistor T3 on the substrate and the orthographic projection of the second light-emitting control signal line EM2 on the substrate.

The above configuration enables the power control transistor T5 and the driving transistor T3 to be located on the same side of the first light-emitting control signal line EM1, which is more conducive to coupling between the power control transistor T5 and the driving transistor T3 and reduces the layout difficulty of the display substrate.

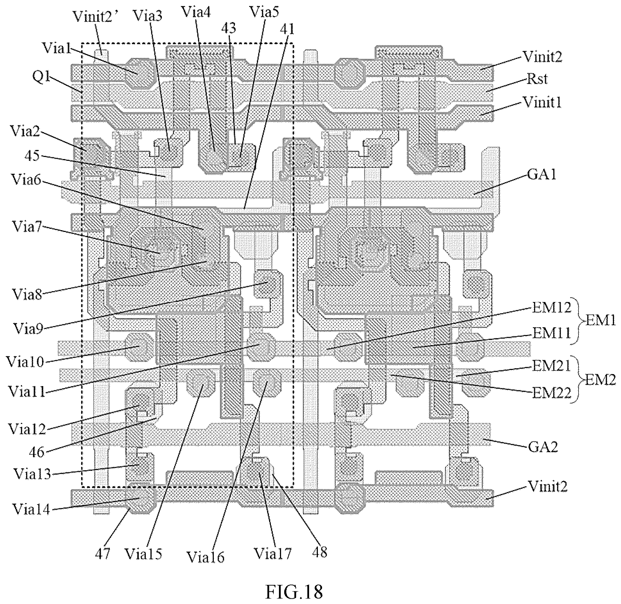

As shown in FIG. 18, in some embodiments, the display substrate further include a plurality of data lines DA and a plurality of second scanning lines GA2; the sub-pixel driving circuit further include a data writing transistor T4, a gate of the data writing transistor T4 is coupled to the corresponding second scanning line GA2, a first electrode of the data writing transistor T4 is coupled to the corresponding data line DA, and a second electrode of the data writing transistor T4 is coupled to the first electrode of the driving transistor T3;
In the layout area of the same sub-pixel driving circuit, the first light-emitting control signal line EM1, the second light-emitting control signal line EM2 and the second scanning line GA2 are sequentially arranged along a second direction, and the second direction intersects with the first direction.

Exemplarily, the plurality of data lines DA are arranged along the first direction, and the data lines DA include at least a portion extending along the second direction. The plurality of data lines DA correspond to the plurality of columns of sub-pixel driving circuits one by one. The data lines DA are respectively coupled to the first electrodes of the data writing transistors T4 in the corresponding column of sub-pixel driving circuits.

Exemplarily, the plurality of second scanning lines GA2 are arranged along the second direction, and the second scanning lines GA2 include at least a portion extending along the first direction. The plurality of second scanning lines GA2 correspond one-to-one to a plurality of rows of sub-pixel driving circuits. The second scanning lines GA2 are respectively coupled to the gates of the data writing transistors T4 in the corresponding row of sub-pixel driving circuits.

In the display substrate provided by the above embodiment, by being arranged in the layout area of the same sub-pixel driving circuit, the orthographic projection of the first light-emitting control signal line EM1 on the base substrate, the orthographic projection of the second light-emitting control signal line EM2 on the base substrate, and the orthographic projection of the second scanning line GA2 on the base substrate are arranged in sequence, which reasonably utilizes the limited layout space and reduces the difficulty of partial layout of the display substrate in the limited layout space.

As shown in FIGS. 13, 15 and 18, in some embodiments, the second electrode of the data writing transistor T4, the first electrode of the driving transistor T3 and the second electrode of the power control transistor T5 are coupled to form a second node portion N2; the first electrode of the light-emitting control transistor T6 is coupled to the second electrode of the driving transistor T3 to form a third node portion N3;
The orthographic projection of the first light-emitting control signal line EM1 on the base substrate at least partially overlaps with the orthographic projection of the second node portion N2 on the base substrate; and/or, the orthographic projection of the first light-emitting control signal line EM1 on the base substrate at least partially overlaps with the orthographic projection of the third node portion N3 on the base substrate; and/or, the orthographic projection of the second light-emitting control signal line EM2 on the base substrate at least partially overlaps with the orthographic projection of the second node portion on the base substrate.

As shown in FIGs. 11 and 13, exemplarily, the second electrode of the data writing transistor T4, the first electrode of the driving transistor T3 and the second electrode of the power control transistor T5 are all arranged in the same layer and material as the active layer in the display substrate, and the second electrode of the data writing transistor T4, the first electrode of the driving transistor T3 and the second electrode of the power control transistor T5 form an integrated structure, and together form a second node portion N2.

Exemplarily, the first electrode of the light-emitting control transistor T6 and the second electrode of the driving transistor T3 are both arranged in the same layer and the same material as the active layer in the display substrate, and the first electrode of the light-emitting control transistor T6 and the second electrode of the driving transistor T3 form an integrated structure, and together form a third node portion N3.

Exemplarily, an orthographic projection of the second light-emitting control signal line EM2 on the base substrate does not overlap with an orthographic projection of the third node portion N3 on the base substrate.

Exemplarily, the first light-emitting control signal line EM1 include a plurality of first light-emitting control parts EM11 and a plurality of second light-emitting control parts EM12, the first light-emitting control parts EM11 and the second light-emitting control parts EM12 are alternately arranged along a first direction, and adjacent first light-emitting control parts EM11 and second light-emitting control parts EM12 are coupled; the first light-emitting control part EM11 and the gate of the power control transistor T5 are arranged in a different layer, the second light-emitting control part EM12 and the gate of the power control transistor T5 are arranged in the same layer, and the orthographic projection of the first light-emitting control part EM11 on the substrate at least partially overlaps with the orthographic projection of the second node portion on the substrate.

Exemplarily, an orthographic projection of the first light emission control portion EM11 on the substrate at least partially overlaps with an orthographic projection of the third node portion N3 on the substrate.

Exemplarily, the second light-emitting control signal line EM2 include a plurality of third light-emitting control parts EM21 and a plurality of fourth light-emitting control parts EM22, the third light-emitting control parts EM21 and the fourth light-emitting control parts EM22 are alternately arranged along a first direction, and adjacent third light-emitting control parts EM21 and the fourth light-emitting control parts EM22 are coupled; the third light-emitting control part EM21 and the gate of the power control transistor T5 are arranged in a different layer, the fourth light-emitting control part EM22 and the gate of the power control transistor T5 are arranged in the same layer, and the orthographic projection of the third light-emitting control part EM21 on the substrate at least partially overlaps with the orthographic projection of the second node portion on the substrate.

The above arrangement reasonably utilizes the limited layout space and reduces the difficulty of partial layout of the display substrate in the limited layout space. At the same time, the above arrangement avoids the formation of an additional transistor structure between the first light-emitting control signal line EM1 and the second light-emitting control signal line EM2 and the second node portion and the third node portion, thereby ensuring the stability of the operation of the sub-pixel driving circuit.

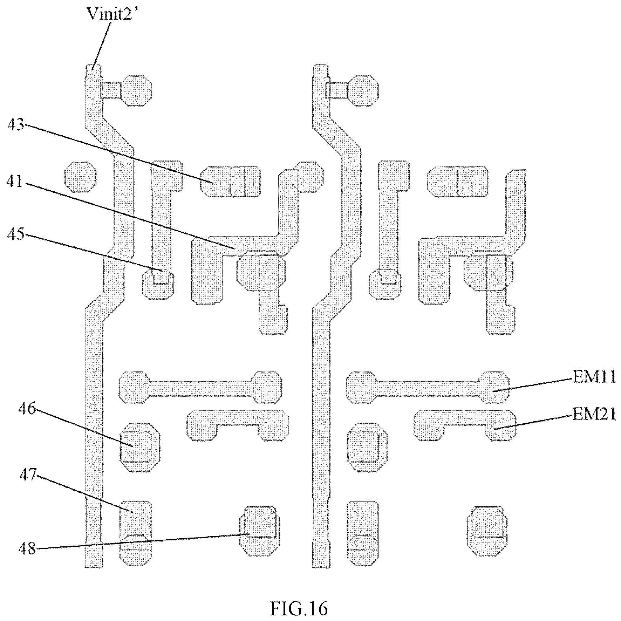

In some embodiments, the display substrate include a first gate metal layer and a first source-drain metal layer stacked in sequence in a direction away from the base substrate;
As shown in FIGs. 12 and 16, the first light-emitting control part EM11 and the third light-emitting control part EM21 are arranged in the same layer and material as the first source and drain metal layer; the second light-emitting control part EM12 and the fourth light-emitting control part EM22 are arranged in the same layer and material as the first gate metal layer.

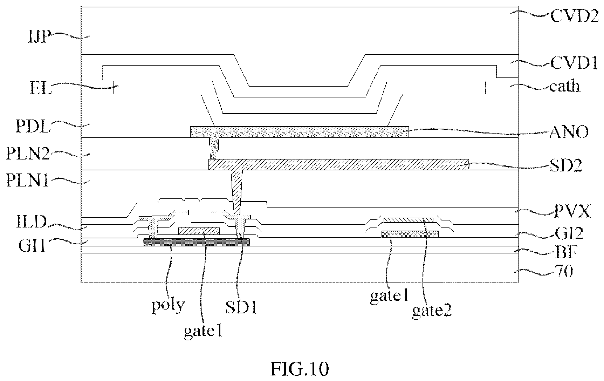

As shown in FIG. 10, exemplarily, the display substrate include a buffer layer BF, an active layer poly, a first gate insulating layer GI1, a first gate metal layer gate1, a second gate insulating layer GI2, a second gate metal layer gate2, an interlayer insulating layer ILD, a first source-drain metal layer SD1, a first flat layer PLN1, a second source-drain metal layer SD2, a second flat layer PLN2, an anode layer ANO, a light-emitting functional layer EL, a cathode layer cath, a first inorganic encapsulation layer CVD1, an organic encapsulation layer IJP, and a second inorganic encapsulation layer CVD2, etc., which are sequentially stacked in a direction away from the base substrate 70. The display substrate may also include a passivation layer PVX, but is not limited thereto.

In the display substrate provided by the above embodiment, by arranging the first light-emitting control part EM11 and the third light-emitting control part EM21 to be in the same layer and material as the first source-drain metal layer, the first light-emitting control part EM11 and the third light-emitting control part EM21 can be formed simultaneously with the first source-drain metal layer in the same patterning process, thereby avoiding adding an additional composition process and simplifying the manufacturing process flow of the display substrate.

In the display substrate provided by the above embodiment, by setting the second light-emitting control part EM12 and the fourth light-emitting control part EM22 to the same layer and the same material as the first gate metal layer, the second light-emitting control part EM12 and the fourth light-emitting control part EM22 can be formed simultaneously with the first gate metal layer in the same composition process, thereby avoiding adding an additional composition process and simplifying the manufacturing process flow of the display substrate.

As shown in FIGS. 11, 13, 15, 16, and 18 to 23, in some embodiments, the display substrate further include a plurality of first scanning lines GA1; the sub-pixel driving circuit further include a compensation transistor T2, a gate of the compensation transistor T2 is coupled to the corresponding first scanning line GA1, a first electrode of the compensation transistor T2 is coupled to the second electrode of the driving transistor T3, and a second electrode of the compensation transistor T2 is coupled to the gate T3-g of the driving transistor T3;
The compensation transistor T2 include a compensation active layer 22, and the compensation active layer 22 include two channel parts 221 and a conductor part 222 respectively coupled to the two channel parts 221;
The sub-pixel driving circuit also include a shielding portion 30 and a first conductive connecting portion 41; the orthographic projection of the shielding portion 30 on the substrate at least partially overlaps with the orthographic projection of the conductor portion 222 on the substrate; the first conductive connecting portion 41 is coupled to the shielding portion 30 and the power line VDD respectively.

Exemplarily, the plurality of first scanning lines GA1 are arranged along the second direction, and the first scanning lines GA1 include at least a portion extending along the first direction. The plurality of first scanning lines GA1 correspond one-to-one to the plurality of rows of sub-pixel driving circuits, and the first scanning lines GA1 are respectively coupled to the gates of the compensation transistors T2 in the corresponding row of sub-pixel driving circuits.

Exemplarily, the compensation transistor T2 include a dual-gate transistor. The compensation transistor T2 include a compensation active layer 22, the compensation active layer 22 include two channel portions and a conductor portion respectively coupled to the two channel portions, and the compensation active layer 22 is also used to form a first electrode and a second electrode of the compensation transistor T2. The orthographic projection of the channel portion on the substrate overlaps with the orthographic projection of the gate of the compensation transistor T2 on the substrate, and the orthographic projection of the conductor portion on the substrate does not overlap with the orthographic projection of the gate of the compensation transistor T2 on the substrate.

Exemplarily, the shielding portion 30 is provided in the same layer and material as the second gate metal layer. The first conductive connection portion is provided in the same layer and material as the first source-drain metal layer.

In the display substrate provided by the above embodiment, the first conductive connection portion is arranged to be coupled to the shielding portion 30 and the power line VDD respectively, so that the shielding portion 30 has a stable potential that is the same as the power signal, and the orthographic projection of the shielding portion 30 on the base substrate is arranged to at least partially overlap with the orthographic projection of the conductor portion on the base substrate, which can well shield the external interference to the conductor portion, ensure the characteristics of the compensation transistor T2, and thus well ensure the working stability of the display substrate.

As shown in FIGs. 11, 13, 15, 16, and 18 to 23, in some embodiments, the sub-pixel driving circuit also include a storage capacitor Cst, and the first plate Cst1 of the storage capacitor Cst is coupled to the gate T3-g of the driving transistor T3; the first conductive connection portion 41 is also coupled to the second plate Cst2 of the storage capacitor Cst and /or the first electrode of the power control transistor T5.

Exemplarily, the first plate Cst1 of the storage capacitor Cst is reused as the gate T3 - g of the driving transistor T3. The second plate Cst2 of the storage capacitor Cst is provided in the same layer and material as the second gate metal layer.

The above-mentioned arrangement of the first conductive connecting portion 41 being respectively coupled to the second electrode plate Cst2 of the storage capacitor Cst, the first electrode of the power control transistor T5, the shielding portion 30 and the power line VDD effectively reduces the complexity of the sub-pixel driving circuit, reduces the layout space occupied by the sub-pixel driving circuit, and reduces the layout difficulty of the display substrate.

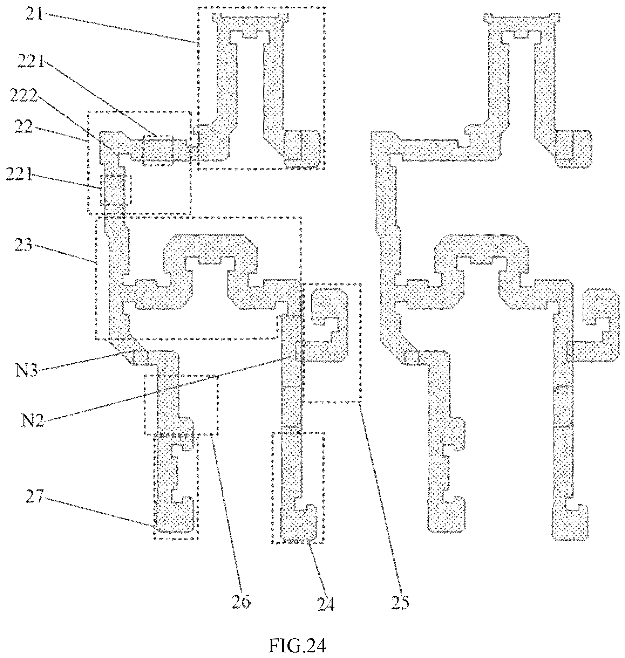

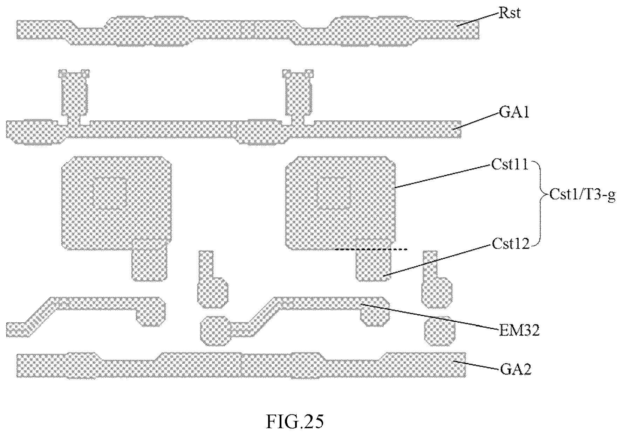

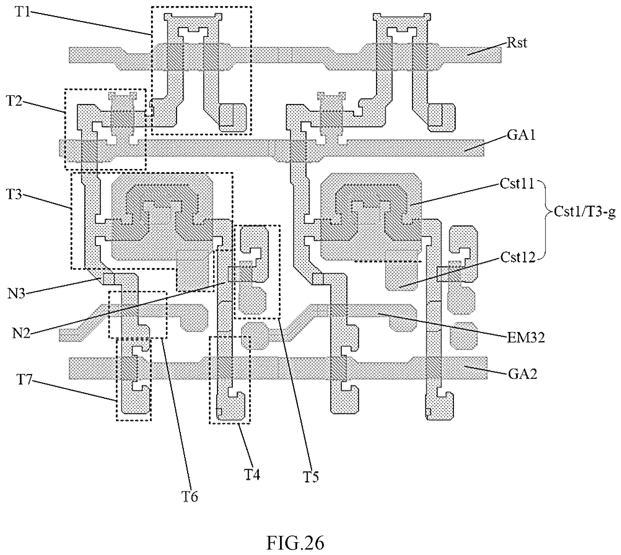

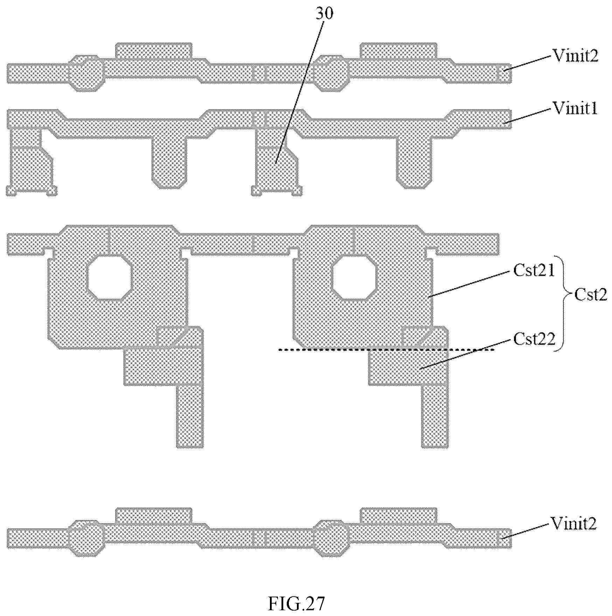

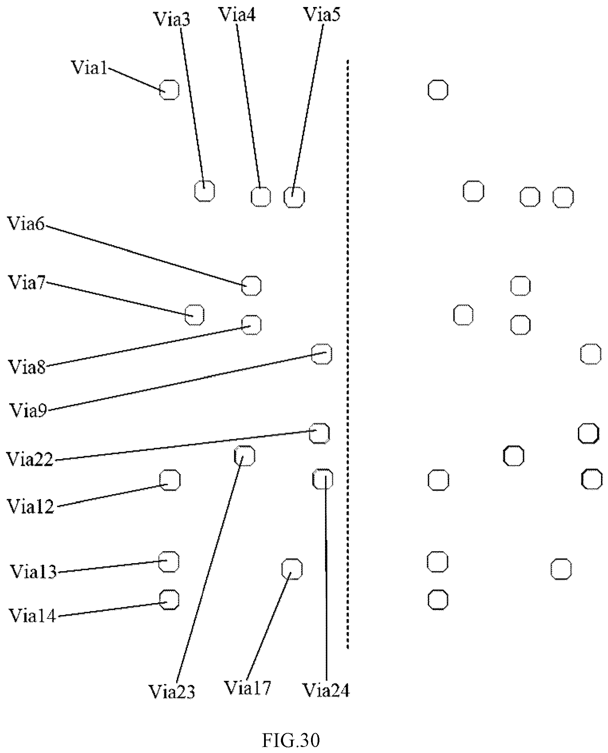

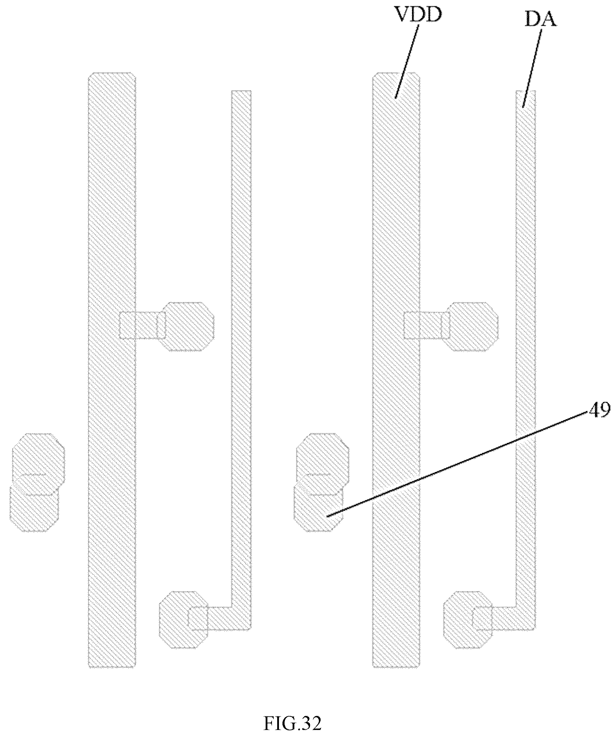

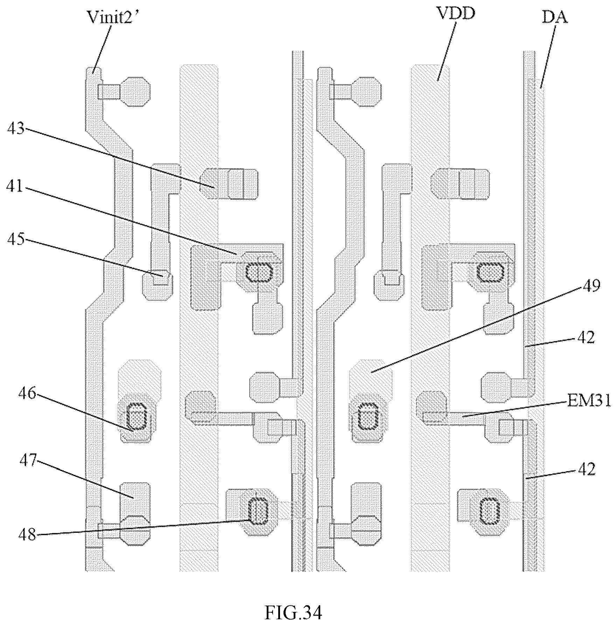

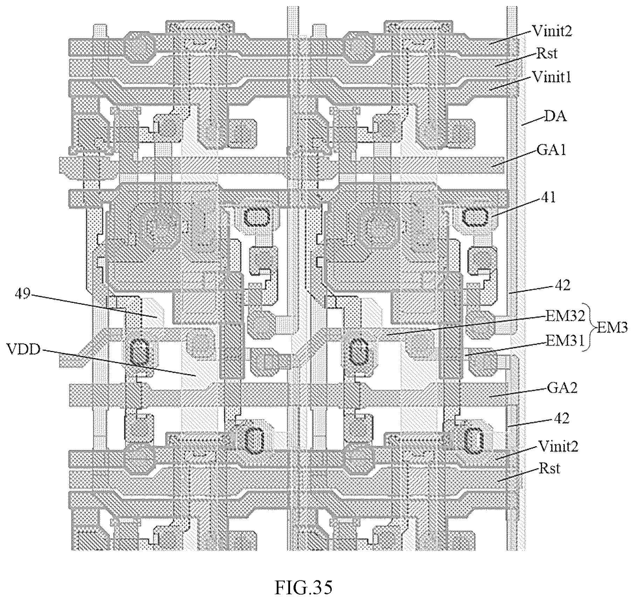

As shown in FIGS. 24 to 35, in some embodiments, the plurality of light-emitting control signal lines include a plurality of third light-emitting control signal lines EM3;
In the same sub-pixel driving circuit, the gate of the light-emitting control transistor T6 is coupled to the corresponding third light-emitting control signal line EM3, and at least a portion of the third light-emitting control signal line EM3 is located in the layout area Q1 of the same sub-pixel driving circuit. The gate of the power control transistor T5 is coupled to the third light-emitting control signal line EM3 coupled to the gate of the light-emitting control transistor T6 in the previous sub-pixel driving circuit adjacent along the second direction.

Exemplarily, the plurality of third light-emitting control signal lines EM3 are arranged along the second direction, and the third light-emitting control signal lines EM3 include at least a portion extending along the first direction. The plurality of third light-emitting control signal lines EM3 correspond one-to-one to the plurality of rows of sub-pixel driving circuits, and the third light-emitting control signal lines EM3 are respectively coupled to the gates of the light-emitting control transistors T6 in the corresponding row of sub-pixel driving circuits.

Exemplarily, at least a portion of the third light-emitting control signal line EM3 is located within a layout area where a corresponding row of sub-pixel driving circuits are located.

Exemplarily, the gate of the power control transistor T5 in the current sub-pixel driving circuit is coupled to the third light-emitting control signal line EM3 coupled to the gate of the light-emitting control transistor T6 in the previous sub-pixel driving circuit adjacent to the second direction.

In the display substrate provided by the above embodiment, only one third light-emitting control signal line EM3 is arranged in the layout area where each row of sub-pixel driving circuits is located, thereby reducing the layout complexity in the layout area where the sub-pixel driving circuits are located. At the same time, the above arrangement enables the light-emitting control transistor T6 and the power supply control transistor T5 in the same sub-pixel driving circuit to be controlled by different third light-emitting control signal lines EM3, thereby realizing independent control of the power supply control transistor T5 and the light-emitting control transistor T6 in the same sub-pixel driving circuit.

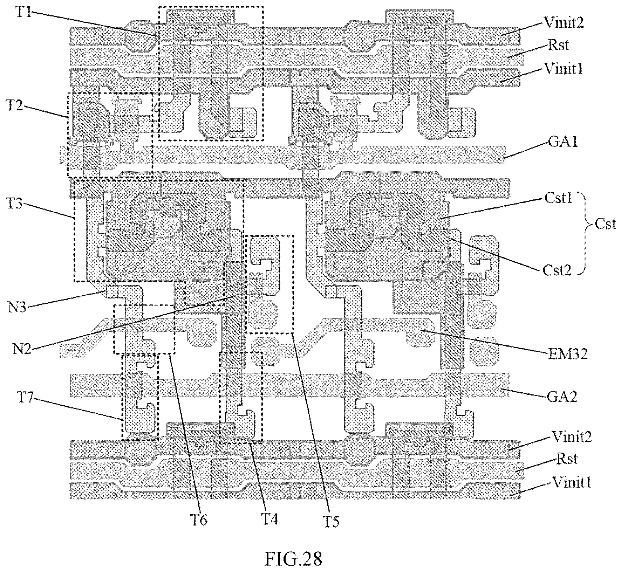

As shown in FIGs. 28, 29, 31 and 33, in some embodiments, the sub-pixel driving circuit also include a second conductive connection portion 42, a first end of the second conductive connection portion 42 is coupled to the gate of the power control transistor T5 in the current sub-pixel driving circuit, and a second end of the second conductive connection portion 42 is coupled to the third light-emitting control signal line EM3 coupled to the previous sub-pixel driving circuit adjacent to the current sub-pixel driving circuit along the second direction.

Exemplarily, the second conductive connection portion 42 include at least a portion extending along the second direction.

Exemplarily, the second conductive connection portion 42 and the data line DA are disposed in different layers. The orthographic projection of the second conductive connection portion 42 on the base substrate at least partially overlaps with the orthographic projection of the data line DA on the base substrate.

In the display substrate provided by the above embodiment, by setting the second conductive connection portion 42, the gate of the power control transistor T5 in the current sub-pixel driving circuit is coupled to the third light-emitting control signal line EM3 coupled to the gate of the light-emitting control transistor T6 in the previous sub-pixel driving circuit adjacent along the second direction. By setting the orthographic projection of the second conductive connection portion 42 on the base substrate to at least partially overlap with the orthographic projection of the data line DA on the base substrate, the additional layout space occupied by the second conductive connection portion 42 can be reduced, which is beneficial to reducing the layout difficulty of the display substrate.

As shown in FIGS. 24 to 34, in some embodiments, the display substrate further include a plurality of data lines DA and a plurality of second scanning lines GA2; the sub-pixel driving circuit further include a data writing transistor T4, a gate of the data writing transistor T4 is coupled to the corresponding second scanning line GA2, a first electrode of the data writing transistor T4 is coupled to the corresponding data line DA, and a second electrode of the data writing transistor T4 is coupled to the first electrode of the driving transistor T3;
The second electrode of the data writing transistor T4, the first electrode of the driving transistor T3 and the second electrode of the power control transistor T5 are coupled to form a second node portion N2 together; the orthographic projection of the third light-emitting control signal line EM3 on the substrate at least partially overlaps with the orthographic projection of the second node portion N2 on the substrate.

Exemplarily, the third light-emitting control signal line EM3 include a plurality of fifth light-emitting control parts EM31 and a plurality of sixth light-emitting control parts EM32, the fifth light-emitting control parts EM31 and the sixth light-emitting control parts EM32 are alternately arranged along the first direction, and the adjacent fifth light-emitting control parts EM31 and the sixth light-emitting control parts EM32 are coupled; the fifth light-emitting control part EM31 and the gate of the power control transistor T5 are arranged in a different layer, the sixth light-emitting control part EM32 and the gate of the power control transistor T5 are arranged in the same layer, and the orthographic projection of the fifth light-emitting control part EM31 on the substrate at least partially overlaps with the orthographic projection of the second node portion N2 on the substrate.

The above arrangement reasonably utilizes the limited layout space and reduces the difficulty of partial layout of the display substrate in the limited layout space. At the same time, the above arrangement avoids the formation of an additional transistor structure between the third light-emitting control signal line EM3 and the second node portion N2 and the third node portion N3, thereby ensuring the stability of the operation of the sub-pixel driving circuit.

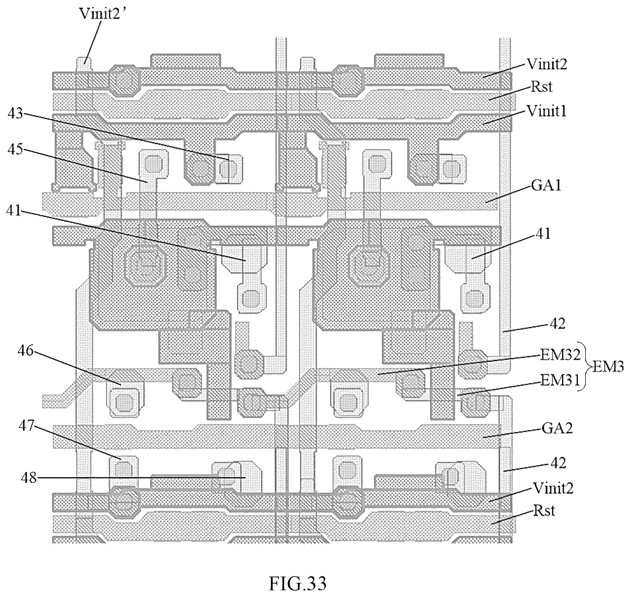

As shown in FIG. 33, in some embodiments, the display substrate include a first gate metal layer and a first source-drain metal layer stacked in sequence in a direction away from the base substrate;
The fifth light-emitting control part EM31 is provided in the same layer and material as the first source-drain metal layer; and/or the second conductive connection part is provided in the same layer and material as the first source-drain metal layer.

In the display substrate provided by the above embodiment, by setting the fifth light-emitting control part EM31 to the same layer and the same material as the first source-drain metal layer, the fifth light-emitting control part EM31 can be formed simultaneously with the first source-drain metal layer in the same patterning process, thereby avoiding adding an additional composition process and simplifying the manufacturing process of the display substrate.

In the display substrate provided in the above embodiment, by setting the second conductive connection part and the first source-drain metal layer in the same layer and the same material, the second conductive connection part can be formed simultaneously with the first source-drain metal layer in the same patterning process, thereby avoiding adding an additional patterning process and simplifying the manufacturing process of the display substrate.

As shown in FIGS. 24, 31 and 33, in some embodiments, the display substrate further include a plurality of first initialization signal lines Vinit1 and a plurality of first scanning lines GA1; the sub-pixel driving circuit further include a compensation transistor T2, a gate of the compensation transistor T2 is coupled to the corresponding first scanning line GA1, a first electrode of the compensation transistor T2 is coupled to a second electrode of the driving transistor T3, and a second electrode of the compensation transistor T2 is coupled to a gate T3-g of the driving transistor T3;
The compensation transistor T2 include a compensation active layer 22, and the compensation active layer 22 include two channel parts 221 and a conductor part 222 respectively coupled to the two channel parts 221;
is coupled to the corresponding first initialization signal line Vinit1; an orthographic projection of the shielding portion 30 on the substrate at least partially overlaps with an orthographic projection of the conductor portion on the substrate.

Exemplarily, the plurality of first initialization signal lines Vinit1 are arranged along the second direction, and the first initialization signal line Vinit1 include at least a portion extending along the first direction. The plurality of first initialization signal lines Vinit1 correspond one-to-one to the plurality of rows of sub-pixel driving circuits, and the first initialization signal line Vinit1 is respectively coupled to the first electrodes of the first reset transistors T1 in the corresponding row of sub-pixel driving circuits.

Exemplarily, the first reset transistor T1 includes a dual-gate transistor, the first reset transistor T1 includes a first reset active layer, the first reset active layer includes two channel portions and conductor portions respectively coupled to the two channel portions, and the orthographic projection of the second initialization signal line Vinit2 in the display substrate on the substrate at least partially overlaps with the orthographic projection of the conductor portion on the substrate. This arrangement can better prevent the first reset transistor T1 from receiving external interference and ensure the characteristics of the first reset transistor T1.

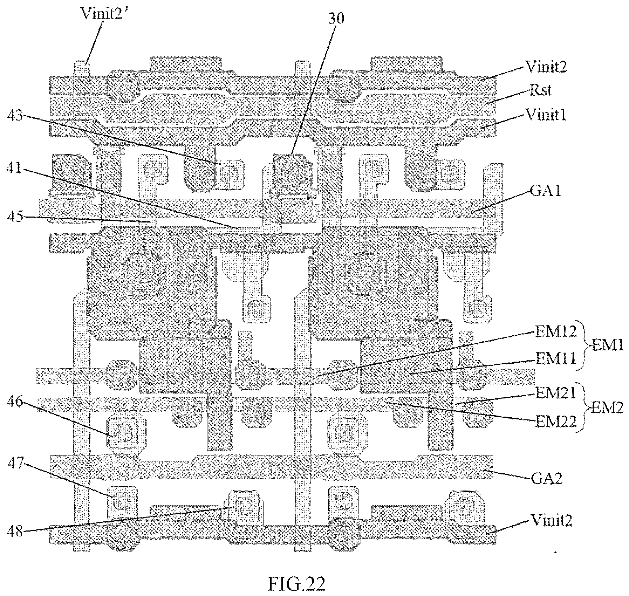

Exemplarily, as shown in FIGs. 22 and 33, the display substrate also include a compensation initialization signal line Vinit2', the compensation initialization signal line Vinit2' include at least a portion extending along the second direction, the compensation initialization signal line Vinit2' is coupled to at least a portion of the second initialization signal line Vinit2, and can form a grid structure with at least a portion of the second initialization signal line Vinit2, which is beneficial to improving the uniformity of the second initialization signal line Vinit2 and reducing the loading of the second initialization signal line Vinit2.

Exemplarily, the shielding portion 30 and the corresponding first initialization signal line Vinit1 are formed into an integrated structure.

The shielding portion 30 is coupled to the corresponding first initialization signal line Vinit1, so that the shielding portion 30 has the same stable potential as the first initialization signal, and the orthographic projection of the shielding portion 30 on the base substrate is set to at least partially overlap with the orthographic projection of the conductor portion on the base substrate, which can well shield the external interference to the conductor portion, ensure the characteristics of the compensation transistor T2, and thus well ensure the working stability of the display substrate.

As shown in FIGs. 28 to 34, in some embodiments, the sub-pixel driving circuit also include a first conductive connection portion 41 and a storage capacitor Cst; the first plate Cst1 of the storage capacitor Cst is coupled to the gate T3-g of the driving transistor T3; the first conductive connection portion 41 is respectively coupled to the power line VDD, the second plate Cst2 of the storage capacitor Cst, and the first electrode of the power control transistor T5.

The above-mentioned arrangement of the first conductive connection portion 41 being respectively coupled to the second electrode plate Cst2 of the storage capacitor Cst, the first electrode of the power control transistor T5 and the power line VDD effectively reduces the complexity of the sub-pixel driving circuit, reduces the layout space occupied by the sub-pixel driving circuit, and reduces the layout difficulty of the display substrate.

As shown in FIGs. 12 to 18 and Figures 28 to 34, in some embodiments, the sub-pixel driving circuit also include a storage capacitor Cst, a first plate Cst1 of the storage capacitor Cst is coupled to the gate T3-g of the driving transistor T3, and a second plate Cst2 of the storage capacitor Cst is coupled to the power line VDD; the orthographic projection of the second plate Cst2 on the substrate at least partially overlaps with the orthographic projection of the second node portion N2 on the substrate.

Since the second electrode plate Cst2 of the storage capacitor Cst has the same stable potential as the power signal, the above configuration enables the second electrode plate Cst2 to shield the interference of peripheral signals on the second node portion N2, thereby ensuring the stability of the second node portion N2.

As shown in FIGS. 12 to 18 and 28 to 34, in some embodiments, the orthographic projection of the second electrode plate Cst2 on the base substrate at least partially overlaps with the orthographic projection of the third node portion N3 in the sub-pixel driving circuit on the base substrate.

Since the second electrode Cst2 of the storage capacitor Cst has the same stable potential as the power signal, the above configuration enables the second electrode Cst2 to shield the interference of peripheral signals on the third node portion N3, thereby ensuring the stability of the third node portion N3.

As shown in FIGS. 12 to 18 and 28 to 34, in some embodiments, the first electrode plate Cst1 include a first electrode plate body portion Cst11 and a first electrode plate protrusion portion Cst12; the second electrode plate Cst2 include a second electrode plate body portion Cst21 and a second electrode plate protrusion portion Cst22;
The orthographic projection of the first electrode main body Cst11 on the base substrate at least partially overlaps with the orthographic projection of the second electrode main body Cst21 on the base substrate; the orthographic projection of the first electrode protrusion Cst12 on the base substrate at least partially overlaps with the orthographic projection of the second electrode protrusion Cst22 on the base substrate;
The orthographic projection of the second electrode protrusion Cst22 on the base substrate at least partially overlaps with the orthographic projection of the second node portion N2 on the base substrate; and/or the orthographic projection of the second electrode protrusion Cst22 on the base substrate at least partially overlaps with the orthographic projection of the third node portion N3 on the base substrate.

The above-mentioned setting that the orthographic projection of the first electrode protrusion Cst12 on the base substrate at least partially overlaps the orthographic projection of the second electrode protrusion Cst22 on the base substrate increases the capacitance value of the storage capacitor Cst, which is beneficial to improving the driving performance of the sub-pixel driving circuit.

The above configuration can effectively shield the interference of the peripheral signals on the second node portion N2 and the third node portion N3, thereby ensuring the stability of the third node portion N3.

In some embodiments, the display substrate include a display area and a peripheral area located around the display area;
The display substrate further include a plurality of first shift register units all located in the peripheral area;
In the same sub-pixel driving circuit, the second light-emitting control signal line EM2 coupled to the gate of the light-emitting control transistor T6 is coupled to the corresponding first shift register unit, and the first light-emitting control signal line EM1 coupled to the gate of the power control transistor T5 is coupled to the first shift register unit coupled to the gate of the light-emitting control transistor T6 in the sub-pixel driving circuit adjacent along the second direction.

Exemplarily, the peripheral area surrounds the display area, but is not limited thereto.

Exemplarily, the display substrate is provided with the plurality of first shift register units only in a peripheral region located on the left side or the right side thereof, but the present diclosure is not limited thereto.

Exemplarily, the second light-emitting control signal line EM2 coupled to the gate of the light-emitting control transistor T6 is coupled to the corresponding first shift register unit in the peripheral area. The first light-emitting control signal line EM1 coupled to the gate of the power control transistor T5 is coupled to the first shift register unit coupled to the gate of the light-emitting control transistor T6 in the adjacent sub-pixel driving circuit along the second direction in the peripheral area.

In the display substrate provided in the above embodiment, the display substrate is arranged to include a first light-emitting control signal line EM1 and a second light-emitting control signal line EM2, the second light-emitting control signal line EM2 is coupled to the first shift register unit corresponding to the sub-pixel driving circuit of the row coupled thereto, and the first light-emitting control signal line EM1 is coupled to the first shift register unit corresponding to the sub-pixel driving circuit of the previous row adjacent to the sub-pixel driving circuit of the row coupled thereto along the second direction.

In the display substrate provided in the above embodiment, the display substrate may be configured to include a first compensation shift register unit, so that the first light-emitting control signal line EM1 coupled to the first row of sub-pixel driving circuits may be coupled to the first compensation shift register unit.

In some embodiments, the display substrate include a display area and a peripheral area located around the display area;
The display substrate further includes a plurality of first shift register units and a plurality of second shift register units, all of which are located in the peripheral area, and the display area is located between the first shift register units and the second shift register units;
The first shift register unit is coupled to the corresponding first light-emitting control signal line EM1, and the second shift register unit is coupled to the corresponding second light-emitting control signal line EM2.

Exemplarily, the plurality of first shift register units are located in a peripheral area on the left side of the display substrate, and the plurality of second shift register units are located in a peripheral area on the right side of the display substrate, but not limited thereto.

Exemplarily, the plurality of first shift register units correspond one-to-one to the plurality of rows of sub-pixel driving circuits, and the plurality of second shift register units correspond one-to-one to the plurality of rows of sub-pixel driving circuits.

Exemplarily, the first shift register unit is controlled by a first clock signal line CK1 and a second clock signal line CK2, and the second shift register unit is controlled by a third clock signal line CK3 and a fourth clock signal line CK4.

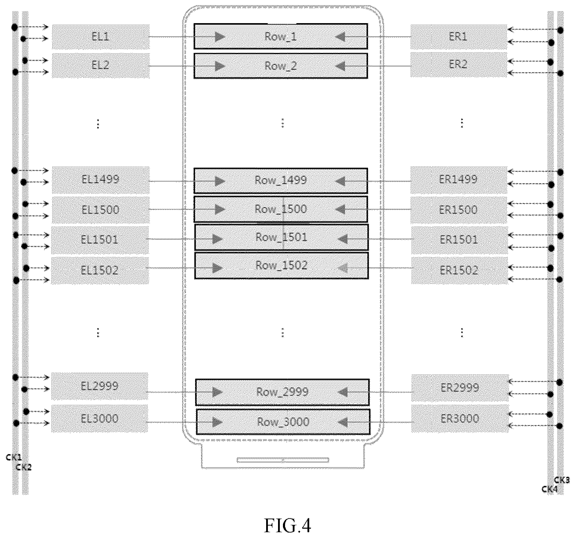

It should be noted that FIG4 illustrates the first row of sub-pixel driving circuits Row_1 to the 3000th row of sub-pixel driving circuits Row_3000 in the display substrate, illustrates a plurality of first shift register units (i.e., EL1 to EL3000) located on the left side of the display area, and illustrates a plurality of second shift register units (i.e., ER1 to EL3000) located on the right side of the display area.

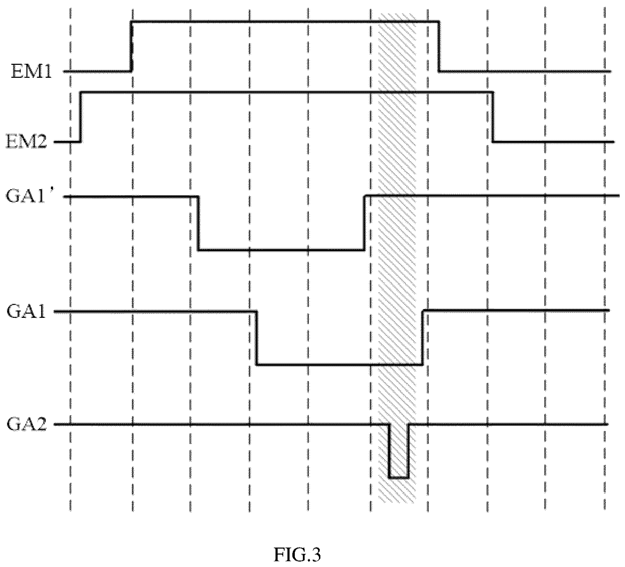

In the display substrate provided in the above embodiment, the first light-emitting control signal line EM1 and the second light-emitting control signal line EM2 are driven on one side respectively and are independently controlled by two groups of shift register units (i.e., a plurality of first shift register units as one group and a plurality of second shift register units as another group). This method makes better use of the layout space of the peripheral area of the display substrate and better realizes the driving of the light-emitting control signal line. In more detail, as shown in FIG3, the first light-emitting control signal line EM1 is driven by the first shift register unit coupled thereto, and the second light-emitting control signal line EM2 is driven by the second shift register unit coupled thereto. The figure illustrates the timing of the first light-emitting control signal transmitted by the first light-emitting control signal line EM1 and the timing of the second light-emitting control signal transmitted by the second light-emitting control signal line EM2.

In some embodiments, the first light-emitting control signal line is formed as an integral structure; and /or the second light-emitting control signal line is formed as an integral structure.

Exemplarily, the first light-emitting control signal line and/or the second light-emitting control signal line are made of a single film layer. For example, the first light-emitting control signal line and/or the second light-emitting control signal line are arranged in the same layer and material as the first gate metal layer, but not limited thereto.

In the above-mentioned arrangement, the first light-emitting control signal line and/or the second light-emitting control signal line does not require a conversion film layer in the display area, thereby avoiding the production of via-holes for the conversion film layer in the display area, thereby reducing the difficulty of layout of the display substrate in a limited space, which is beneficial to improving the resolution of the display substrate.

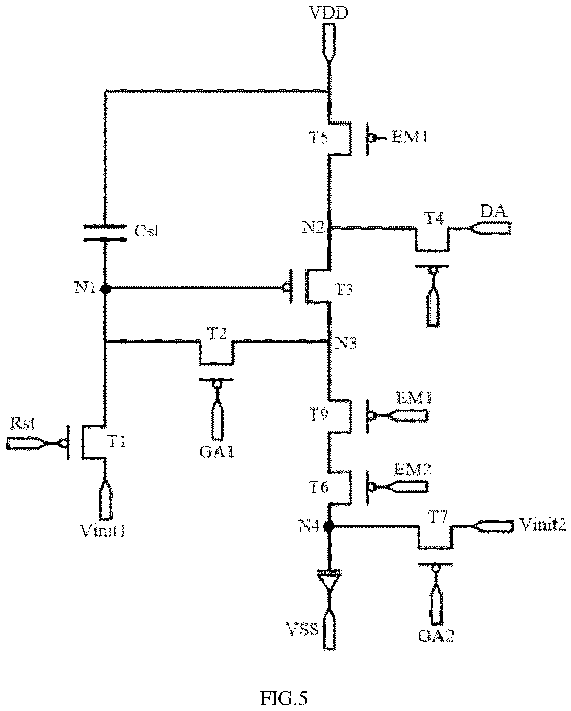

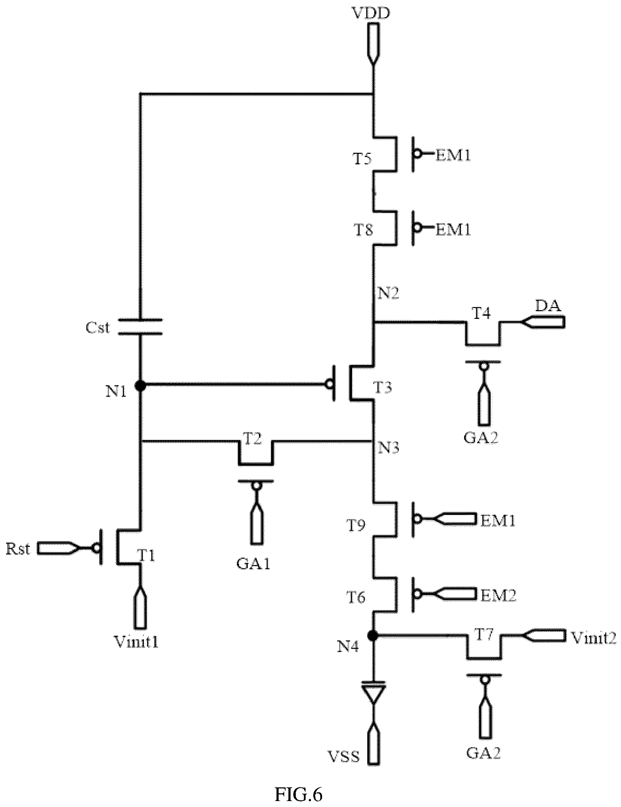

As shown in FIG. 5 and FIG. 6, in some embodiments, the first light-emitting control signal line is provided in the same layer and material as the first gate metal layer included in the display substrate;
The first light-emitting control signal line EM1 and the third node portion N3 form a first transmission transistor T9, the first light-emitting control signal line EM1 is multiplexed as a gate of the first transmission transistor T9, a first electrode of the first transmission transistor T9 is coupled to a second electrode of the driving transistor T3, and a second electrode of the first transmission transistor T9 is coupled to a first electrode of the light-emitting control transistor T6; and/or,
The first light-emitting control signal line EM1 and the second node portion N2 form a second transmission transistor T8, the first light-emitting control signal line EM1 is multiplexed as the gate of the second transmission transistor T8, the first electrode of the second transmission transistor T8 is coupled to the second electrode of the power control transistor T5, and the second electrode of the second transmission transistor T8 is respectively coupled to the first electrode of the driving transistor T3 and the second electrode of the data writing transistor T4.

In the display substrate provided in the above embodiment, the first light-emitting control signal line EM1 is arranged in the same layer and the same material as the first gate metal layer, so that the first light-emitting control signal line EM1 does not need a conversion film layer in the display area, avoiding the need to make via-holes for the conversion film layer in the display area, thereby reducing the difficulty of layout of the display substrate in a limited space, which is beneficial to improving the resolution of the display substrate. In the display substrate provided in the above embodiment, the first light-emitting control signal line EM1 is arranged in the same layer and the same material as the first gate metal layer, so that the first light-emitting control signal line EM1 and the third node portion N3 form an additional first transfer transistor T9, and/or the first light-emitting control signal line EM1 and the second node portion N2 form an additional first transfer transistor T9, and the additional transistor will not affect the normal driving of the sub-pixel driving circuit.

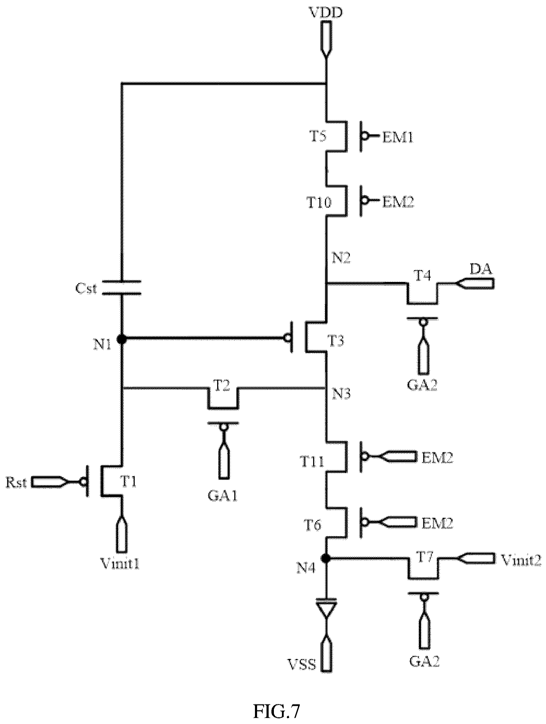

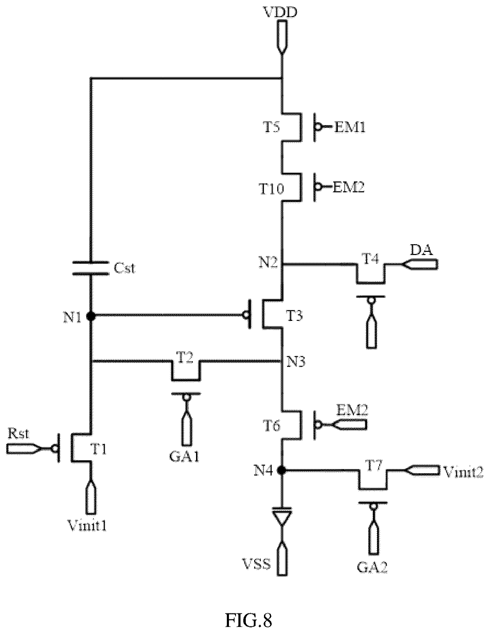

As shown in FIG. 7 and FIG. 8, in some embodiments, the second light-emitting control signal line EM2 is provided in the same layer and material as the first gate metal layer included in the display substrate;
The second light-emitting control signal line EM2 and the second node portion N2 form a third transmission transistor T10, the second light-emitting control signal line EM2 is multiplexed as a gate of the third transmission transistor T10, a first electrode of the third transmission transistor T10 is coupled to a second electrode of the power control transistor T5, and a second electrode of the third transmission transistor T10 is respectively coupled to a first electrode of the driving transistor T3 and a second electrode of the data writing transistor T4; and/or,
The second light-emitting control signal line EM2 and the third node portion N3 form a fourth transfer transistor T11, the second light-emitting control signal line EM2 is multiplexed as the gate of the fourth transfer transistor T11, the first electrode of the fourth transfer transistor T11 is coupled to the second electrode of the driving transistor T3, and the second electrode of the fourth transfer transistor T11 is coupled to the first electrode of the light-emitting control transistor T6.

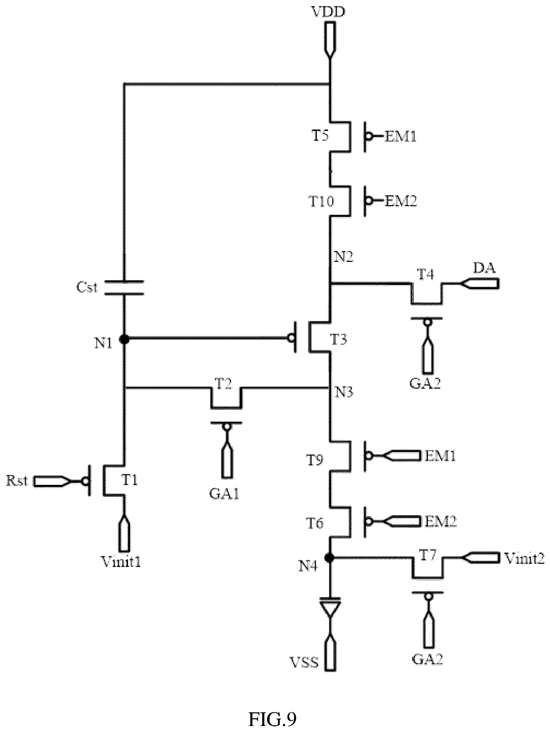

As shown in FIG. 9, in some embodiments, the first light-emitting control signal line EM1 and the second light-emitting control signal line EM2 are both provided in the same layer and the same material as the first gate metal layer;
The second light-emitting control signal line EM2 and the second node portion N2 form a third transmission transistor T10, the second light-emitting control signal line EM2 is multiplexed as a gate of the third transmission transistor T10, a first electrode of the third transmission transistor T10 is coupled to a second electrode of the power control transistor T5, and a second electrode of the third transmission transistor T10 is respectively coupled to a first electrode of the driving transistor T3 and a second electrode of the data writing transistor T4; and/or,
The first light-emitting control signal line EM1 and the third node portion N3 form a first transmission transistor T9, the first light-emitting control signal line EM1 is multiplexed as the gate of the first transmission transistor T9, the first electrode of the first transmission transistor T9 is coupled to the second electrode of the driving transistor T3, and the second electrode of the first transmission transistor T9 is coupled to the first electrode of the light-emitting control transistor T6.

FIGs. 11 and 24, the figure illustrates the first reset active layer 21 included in the first reset transistor T1, the compensation active layer 22 included in the compensation transistor T2, the driving active layer 23 included in the driving transistor T3, the data writing active layer 24 included in the data writing transistor T4, the power control active layer 25 included in the power control transistor T5, the light-emitting control active layer 26 included in the light-emitting control transistor T6, and the second reset active layer 27 included in the second reset transistor T7.

As shown in FIGs. 16 to 20, the first conductive connection part 41 is coupled to the second electrode Cst2 of the storage capacitor Cst through the sixth via Via6 and the eighth via Via8, the first conductive connection part 41 is coupled to the shielding part 30 through the second via Via2, the first conductive connection part 41 is coupled to the first electrode of the power control transistor T5 through the ninth via Via9, and the first conductive connection part 41 is coupled to the power line VDD through the eighteenth via Via18.

As shown in FIGS. 16 to 20, the third conductive connection portion 43 is coupled to the first initialization signal line Vinit1 through the fourth via hole Via4, and the third conductive connection portion 43 is coupled to the first electrode of the first reset transistor T1 through the fifth via hole Via5.

As shown in FIGS. 16 to 20, the fifth conductive connection portion 45 is coupled to the second electrode of the first reset transistor T1 and the second electrode of the compensation transistor T2 through the third via Via3, and the fifth conductive connection portion 45 is coupled to the gate T3 - g of the driving transistor T3 through the seventh via Via7.

As shown in FIGs.16 to 20, the sixth conductive connection part 46 is coupled to the second electrode of the light-emitting control transistor T6 and the second electrode of the second reset transistor T7 through the twelfth via Via12, the sixth conductive connection part 46 is coupled to the ninth conductive connection part 49 through the nineteenth via Via19, and the ninth conductive connection part 49 is coupled to the anode of the light-emitting element.

As shown in FIGS. 16 to 20, the seventh conductive connection portion 47 is coupled to the first electrode of the second reset transistor T7 through the thirteenth via hole Via13, and the seventh conductive connection portion 47 is coupled to the second initialization signal line Vinit2 through the fourteenth via hole Via14.

As shown in FIGS. 16 to 20, the eighth conductive connection portion 48 is coupled to the first electrode of the data writing transistor T4 through the seventeenth via-hole Via17, and the eighth conductive connection portion 48 is coupled to the data line DA through the twentieth via hole Via20.

As shown in FIGS. 16 to 20, the first light emission control part EM11 is coupled to the second light emission control part EM12 on one side through the tenth via hole Via10, and is also coupled to the second light emission control part EM12 on the other side through the eleventh via hole Via11.

As shown in FIGS. 16 to 20, the third light emission control part EM21 is coupled to the fourth light emission control part EM22 on one side through the fifteenth via hole Via15, and is also coupled to the fourth light emission control part EM22 on the other side through the sixteenth via hole Via16.

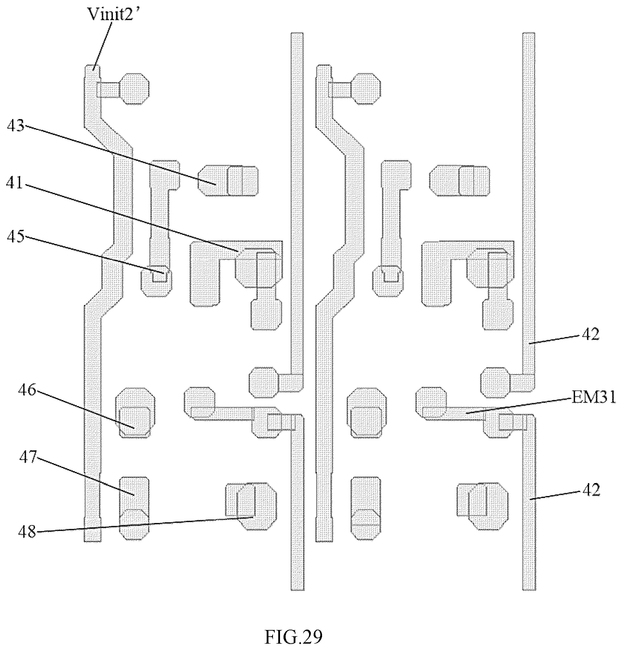

As shown in Figures 29 to 34, the second conductive connection part 42 is coupled to the gate of the power control transistor T5 through the twenty-second via Via22, and the second conductive connection part 42 is coupled to the sixth light-emitting control part EM32 through the twenty-fourth via Via24. The second conductive connection part 42 and the fifth light-emitting control part EM31 form an integrated structure.

As shown in FIGS. 29 to 34, the fifth light-emitting control part EM31 is coupled to the sixth light-emitting control part EM32 through the twenty-third via hole Via23.

An embodiment of the present disclosure further provides a display device, including the display substrate provided by the above embodiment.

**It** should be noted that the display device can be any product or component with a display function, such as a television, a monitor, a digital photo frame, a mobile phone, a tablet computer, etc., where the display device also include a flexible circuit board, a printed circuit board and a backplane, etc.

**In** the display substrate provided by the above embodiment, by setting in the same sub-pixel driving circuit, the gate of the power control transistor and the gate of the light-emitting control transistor are coupled to different light-emitting control signal lines, so that the power control transistor and the light-emitting control transistor in the same sub-pixel driving circuit can be independently controlled by different light-emitting control signal lines, so that the power control transistor and the light-emitting control transistor in the same sub-pixel driving circuit can be controlled to have the same conduction period or different conduction periods according to actual needs. In the display substrate provided by the above embodiment, when the power control transistor in the same sub-pixel driving circuit is controlled to be turned on before the light-emitting control transistor, the power signal transmitted by the power line can be preferentially written to the first electrode of the driving transistor, which is conducive to the improvement of the smear phenomenon. In the display substrate provided by the above embodiment, the sub-pixel driving circuit can be compatible with a variety of circuit structures including the power control transistor and the light-emitting control transistor. In the display substrate provided by the above embodiment, by reasonably controlling the conduction time of the power control transistor and the light-emitting control transistor in the same sub-pixel driving circuit, the display quality of the display product can be effectively improved.

Therefore, the display device provided by the embodiment of the present disclosure, when including the display substrate provided by the above embodiment, also has the above beneficial effects, which will not be described in detail here.

**It** should be noted that the layout area occupied by each sub-pixel driving circuit may be an area that can accommodate the sub-pixel driving circuit. Exemplarily, the area may be a rectangular area, but is not limited thereto.

**It** should be noted that the signal line extends along the X direction means that the signal line include a main part and a secondary part connected to the main part, the main part is a line, a line segment or a strip-shaped body, the main part extends along the X direction, and the length of the main part extending along the X direction is greater than the length of the secondary part extending along other directions.

**It** should be noted that the "same layer" in the embodiment of the present disclosure may refer to a film layer on the same structural layer. Or, for example, a film layer on the same layer may be a film layer for forming a specific pattern formed by the same film forming process, and then the film layer is patterned by the same mask through a single composition process to form a layer structure. Depending on the specific pattern, a single composition process may include multiple exposure, development or etching processes, and the specific pattern in the formed layer structure may be continuous or discontinuous. These specific patterns may also be at different heights or have different thicknesses.

In the various method embodiments of the present disclosure, the serial numbers of the steps cannot be used to limit the sequence of the steps. For ordinary technicians in this field, without paying any creative work, changes to the sequence of the steps are also within the protection scope of the present disclosure.

It should be noted that each embodiment in this specification is described in a progressive manner, and the same or similar parts between the embodiments can be referred to each other, and each embodiment focuses on the differences from other embodiments. In particular, for the method embodiment, since it is basically similar to the product embodiment, the description is relatively simple, and the relevant parts can be referred to the partial description of the product embodiment.

Unless otherwise defined, the technical terms or scientific terms used in the present disclosure should be understood by people with ordinary skills in the field to which the present disclosure belongs. The "first", "second" and similar words used in the present disclosure do not indicate any order, quantity or importance, but are only used to distinguish different components. "Include" or "include" and similar words mean that the elements or objects appearing before the word cover the elements or objects listed after the word and their equivalents, without excluding other elements or objects. "Connect", "couple" or "connected" and similar words are not limited to physical or mechanical connections, but can include electrical connections, whether direct or indirect. "Up", "down", "left", "right" and the like are only used to indicate relative positional relationships. When the absolute position of the described object changes, the relative positional relationship may also change accordingly.

It will be understood that when an element such as a layer, film, region, or substrate is referred to as being "on" or "under" another element, it can be "directly on" or "under" the other element or intervening elements may be present.

In the description of the above embodiments, specific features, structures, materials or characteristics may be combined in a suitable manner in any one or more embodiments or examples.

The above is only a specific embodiment of the present disclosure, but the protection scope of the present disclosure is not limited thereto. Any person skilled in the art who is familiar with the technical field can easily think of changes or substitutions within the technical scope disclosed in the present disclosure, which should be included in the protection scope of the present disclosure. Therefore, the protection scope of the present disclosure should be based on the protection scope of the claims.

## Claims

1. A display substrate, comprising: a base substrate, and a plurality of light-emitting control signal lines, a plurality of power supply lines and a plurality of sub-pixels all arranged on the base substrate, wherein the sub-pixels comprise a sub-pixel driving circuit and a light-emitting element;
the sub-pixel driving circuit comprise a driving transistor, a power control transistor and a light-emitting control transistor; a first electrode of the power control transistor is coupled to a corresponding power line, and a second electrode of the power control transistor is coupled to a first electrode of the driving transistor; a first electrode of the light-emitting control transistor is coupled to a second electrode of the driving transistor, and a second electrode of the light-emitting control transistor is coupled to the light-emitting element;
in the same sub-pixel driving circuit, a gate of the power control transistor and a gate of the light-emitting control transistor are coupled to different light-emitting control signal lines; the light-emitting control signal line comprise at least two light-emitting control parts arranged along a first direction, two adjacent light-emitting control parts are coupled, and two adjacent light-emitting control parts are arranged in different layers.

2. The display substrate according to claim 1, wherein the plurality of light-emitting control signal lines comprise a plurality of first light-emitting control signal lines and a plurality of second light-emitting control signal lines;
in the same sub-pixel driving circuit, a gate of the power control transistor is coupled to the corresponding first light-emitting control signal line, a gate of the light-emitting control transistor is coupled to the corresponding second light-emitting control signal line, and at least part of the first light-emitting control signal line and at least part of the second light-emitting control signal line are located within the layout area of the same sub-pixel driving circuit.

3. The display substrate according to claim 2, wherein at least a portion of an orthographic projection of the first light-emitting control signal line on the base substrate is located between an orthographic projection of the gate of the power control transistor coupled thereto on the base substrate and an orthographic projection of the second light-emitting control signal line on the base substrate.

4. The display substrate according to claim 3, wherein the display substrate further comprises a plurality of data lines and a plurality of second scanning lines; the sub-pixel driving circuit further comprises a data writing transistor, a gate of the data writing transistor is coupled to the corresponding second scanning line, a first electrode of the data writing transistor is coupled to the corresponding data line, and a second electrode of the data writing transistor is coupled to the first electrode of the driving transistor;
in a layout area of a same sub-pixel driving circuit, the first light-emitting control signal line, the second light-emitting control signal line and the second scanning line are arranged in sequence along a second direction, and the second direction intersects with the first direction.

5. The display substrate according to claim 4, wherein a second electrode of the data writing transistor, a first electrode of the driving transistor and a second electrode of the power control transistor are coupled to form a second node portion; the first electrode of the light-emitting control transistor is coupled to the second electrode of the driving transistor to form a third node portion;
an orthographic projection of the first light-emitting control signal line on the substrate at least partially overlaps with an orthographic projection of the second node portion on the substrate; and/or, the orthographic projection of the first light-emitting control signal line on the substrate at least partially overlaps with an orthographic projection of the third node portion on the substrate; and/or, the orthographic projection of the second light-emitting control signal line on the substrate at least partially overlaps with an orthographic projection of the second node portion on the substrate.

6. The display substrate according to claim 5, wherein
the first light-emitting control signal line comprise a plurality of first light-emitting control parts and a plurality of second light-emitting control parts, the first light-emitting control parts and the second light-emitting control parts are alternately arranged along a first direction, and the adjacent first light-emitting control parts and the second light-emitting control parts are coupled; the first light-emitting control parts and the gate of the power control transistor are arranged in different layers, and the second light-emitting control parts and the gate of the power control transistor are arranged in the same layer;
an orthographic projection of the first light-emitting control part on the base substrate at least partially overlaps with the orthographic projection of the second node portion on the base substrate; and/or,
an orthographic projection of the first light-emitting control part on the base substrate at least partially overlaps with the orthographic projection of the third node portion on the base substrate; and/or,
the second light-emitting control signal line comprise a plurality of third light-emitting control parts and a plurality of fourth light-emitting control parts, the third light-emitting control parts and the fourth light-emitting control parts are alternately arranged along a first direction, and adjacent third light-emitting control parts are coupled; the third light-emitting control parts and the gate of the power control transistor are arranged in a different layer, the fourth light-emitting control parts and the gate of the power control transistor are arranged in the same layer, and the orthographic projection of the third light-emitting control parts on the substrate at least partially overlaps with the orthographic projection of the second node portion on the substrate.

7. The display substrate according to claim 6, wherein the display substrate comprises a first gate metal layer and a first source-drain metal layer sequentially stacked in a direction away from the base substrate;
the first light-emitting control part and the third light-emitting control part are provided in the same layer and material as the first source-drain metal layer; the second light-emitting control part and the fourth light-emitting control part are provided in the same layer and material as the first gate metal layer.

8. The display substrate according to claim 2, wherein the display substrate further comprises a plurality of first scanning lines; the sub-pixel driving circuit further comprises a compensation transistor, a gate of the compensation transistor is coupled to the corresponding first scanning line, a first electrode of the compensation transistor is coupled to the second electrode of the driving transistor, and the second electrode of the compensation transistor is coupled to the gate of the driving transistor;
the compensation transistor comprises a compensation active layer, wherein the compensation active layer comprises two channel portions and conductor portions respectively coupled to the two channel portions;
the sub-pixel driving circuit also comprise a shielding portion and a first conductive connection portion; an orthographic projection of the shielding portion on the substrate at least partially overlaps with the orthographic projection of the conductor portion on the substrate; the first conductive connection portion is coupled to the shielding portion and the power line, respectively.

9. The display substrate according to claim 8, wherein the sub-pixel driving circuit further comprises a storage capacitor, a first plate of the storage capacitor is coupled to the gate of the driving transistor; and the first conductive connection portion is further coupled to a second plate of the storage capacitor and /or a first electrode of the power control transistor.

10. The display substrate according to claim 1, wherein the plurality of light emission control signal lines comprise a plurality of third light emission control signal lines;
in the same sub-pixel driving circuit, the gate of the light-emitting control transistor is coupled to the corresponding third light-emitting control signal line, at least part of the third light-emitting control signal line is located within the layout area of the same sub-pixel driving circuit, and the gate of the power control transistor is coupled to the third light-emitting control signal line coupled to the gate of the light-emitting control transistor in the previous sub-pixel driving circuit adjacent along the second direction.

11. The display substrate according to claim 10, wherein the sub-pixel driving circuit further comprises a second conductive connection portion, a first end of the second conductive connection portion is coupled to a gate of a power control transistor in a current sub-pixel driving circuit, and a second end of the second conductive connection portion is coupled to a third light-emitting control signal line coupled to a previous sub-pixel driving circuit adjacent to the current sub-pixel driving circuit along the second direction.

12. The display substrate according to claim 11, wherein the display substrate further comprises a plurality of data lines and a plurality of second scanning lines; the sub-pixel driving circuit further comprises a data writing transistor, a gate of the data writing transistor is coupled to the corresponding second scanning line, a first electrode of the data writing transistor is coupled to the corresponding data line, and a second electrode of the data writing transistor is coupled to the first electrode of the driving transistor;
the second electrode of the data writing transistor, the first electrode of the driving transistor and the second electrode of the power control transistor are coupled to form a second node portion together; the orthographic projection of the third light-emitting control signal line on the substrate at least partially overlaps with the orthographic projection of the second node portion on the substrate.

13. The display substrate according to claim 12, wherein
the third light-emitting control signal line comprise a plurality of fifth light-emitting control parts and a plurality of sixth light-emitting control parts, the fifth light-emitting control parts and the sixth light-emitting control parts are alternately arranged along a first direction, and the adjacent fifth light-emitting control parts are coupled; the fifth light-emitting control part and the gate of the power control transistor are arranged in a different layer, the sixth light-emitting control part and the gate of the power control transistor are arranged in the same layer, and the orthographic projection of the fifth light-emitting control part on the substrate at least partially overlaps with the orthographic projection of the second node portion on the substrate.

14. The display substrate according to claim 13, wherein the display substrate comprises a first gate metal layer and a first source-drain metal layer sequentially stacked in a direction away from the base substrate;
the fifth light-emitting control part is provided in the same layer and the same material as the first source-drain metal layer; and/or the second conductive connection part is provided in the same layer and the same material as the first source-drain metal layer.

15. The display substrate according to claim 10, wherein the display substrate further comprises a plurality of first initialization signal lines and a plurality of first scanning lines; the sub-pixel driving circuit further comprises a compensation transistor, a gate of the compensation transistor is coupled to the corresponding first scanning line, a first electrode of the compensation transistor is coupled to the second electrode of the driving transistor, and the second electrode of the compensation transistor is coupled to the gate of the driving transistor;
the compensation transistor comprises a compensation active layer, wherein the compensation active layer comprises two channel portions and conductor portions respectively coupled to the two channel portions;
the sub-pixel driving circuit further comprises a shielding portion, the shielding portion is coupled to the corresponding first initialization signal line; an orthographic projection of the shielding portion on the base substrate at least partially overlaps with an orthographic projection of the conductor portion on the base substrate.

16. The display substrate according to claim 10, wherein the sub-pixel driving circuit further comprises a first conductive connection portion and a storage capacitor; the first plate of the storage capacitor is coupled to the gate of the driving transistor; the first conductive connection portion is respectively coupled to the power line, a second plate of the storage capacitor, and the first electrode of the power control transistor.

17. The display substrate according to claim 5 or 12, wherein
the sub-pixel driving circuit further comprises a storage capacitor, a first plate of the storage capacitor is coupled to the gate of the driving transistor, and a second plate of the storage capacitor is coupled to the power line;
an orthographic projection of the second electrode plate on the base substrate at least partially overlaps with the orthographic projection of the second node portion on the base substrate.

18. The display substrate according to claim 17, wherein an orthographic projection of the second electrode plate on the base substrate at least partially overlaps an orthographic projection of a third node portion in the sub-pixel driving circuit on the base substrate.

19. The display substrate according to claim 18, wherein the first electrode plate comprises a first electrode plate main body and a first electrode plate protrusion; the second electrode plate comprises a second electrode plate main body and a second electrode plate protrusion;
an orthographic projection of the first electrode main body on the substrate at least partially overlaps with an orthographic projection of the second electrode main body on the substrate; an orthographic projection of the first electrode protrusion on the substrate at least partially overlaps with an orthographic projection of the second electrode protrusion on the substrate;
the orthographic projection of the second electrode plate protrusion on the substrate at least partially overlaps with the orthographic projection of the second node portion on the substrate; and/or the orthographic projection of the second electrode plate protrusion on the substrate at least partially overlaps with the orthographic projection of the third node portion on the substrate.

20. The display substrate according to claim 2, wherein the display substrate comprises a display area and a peripheral area located around the display area;
the display substrate further comprise a plurality of first shift register units all located in the peripheral area;
in the same sub-pixel driving circuit, the second light-emitting control signal line coupled to the gate of the light-emitting control transistor is coupled to the corresponding first shift register unit, and the first light-emitting control signal line coupled to the gate of the power control transistor is coupled to the first shift register unit coupled to the gate of the light-emitting control transistor in the sub-pixel driving circuit adjacent along the second direction.

21. The display substrate according to claim 2, wherein the display substrate comprises a display area and a peripheral area located around the display area;
the display substrate further comprises a plurality of first shift register units and a plurality of second shift register units, all of which are located in the peripheral area, and the display area is located between the first shift register units and the second shift register units;
the first shift register unit is coupled to the corresponding first light-emitting control signal line, and the second shift register unit is coupled to the corresponding second light-emitting control signal line.

22. A display device comprising the display substrate according to any one of claims 1 to 21.
